(19) Europäisches Patentamt European Patent Office Office européen des brevets

(11) **EP 2 881 750 A1**

(12) **EUROPÄISCHE PATENTANMELDUNG**

(43) Veröffentlichungstag:
**10.06.2015 Patentblatt 2015/24**

(51) Int Cl.:
***G01R 33/385*** *(2006.01)*

(21) Anmeldenummer: **14196601.0**

(22) Anmeldetag: **05.12.2014**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **09.12.2013 DE 102013225274**

(71) Anmelder: **Albert-Ludwigs-Universität Freiburg**
**79098 Freiburg (DE)**

(72) Erfinder:
• **Schultz, Gerrit**
 **76199 Karlsruhe (DE)**
• **Zaitsev, Maxim**
 **79117 Freiburg (DE)**
• **Feng, Jia**
 **79115 Freiburg (DE)**

(74) Vertreter: **Kohler Schmid Möbus Patentanwälte**
**Partnerschaftsgesellschaft mbB**
**Ruppmannstraße 27**
**70565 Stuttgart (DE)**

(54) **Gradientensystem für die Magnetresonanzbildgebung**

(57) Ein Gradientensystem für die Magnetresonanzbildgebung, das drei Gradientenspulen (032) umfasst, welche stromführende Leiter (013) aufweisen, die auf planaren oder gekrümmten Flächen (080, 030a) angeordnet sind, wobei die stromführenden Leiter von n der drei Gradientenspulen, mit n=2 oder n=3, in azimutaler Richtung geschlossen, halb-geschlossen oder offen ausgeformt sind (013, 021) und jeweils ein magnetisches Gradientenfeld erzeugen, wobei die Gradientenrichtungen orthogonal zueinander sind, ist dadurch gekennzeichnet, dass die planaren oder gekrümmten Flächen (080, 030a) der n Gradientenspulen spiralförmig (036) und/oder stufenförmig (032) ausgeformt sind, und dass die stromführenden Leiter der n Gradientenspulen identisch ausgeformt sind (038a, 038b, 038c).

Damit lassen sich die Probleme aus dem Stand der Technik elegant umgehen, die vor allem darauf beruhen, dass die bekannten Gradientsysteme aus Spulen bestehen, die zwar im Wesentlichen ähnlich oder sogar nahezu gleich konstruiert sein mögen, jedoch *keine* konsequent *identische Bauweise* aufweisen.

Fig. 3c

EP 2 881 750 A1

**Beschreibung**

Die Erfindung betrifft ein Gradientensystem für die Magnetresonanzbildgebung, das drei Gradientenspulen umfasst, welche stromführende Leiter aufweisen, die auf planaren oder gekrümmten Flächen angeordnet sind, wobei die stromführenden Leiter von n der drei Gradientenspulen, mit n=2 oder n=3, in azimutaler Richtung geschlossen, halbgeschlossen oder offen ausgeformt sind und jeweils ein magnetisches Gradientenfeld erzeugen, wobei die Gradientenrichtungen orthogonal zueinander sind.

Ein solches Gradientensystem ist bekannt aus EP 1 122 552 B1 (= Referenz [P1]).

ERFINDUNGSGEBIET

Die vorliegende Erfindung bezieht sich im Allgemeinen auf das Gebiet der Magnetresonanzbildgebung. Im Speziellen betrifft sie ein neuartiges Gradientensystem für ein Magnetresonanzbildgebungsgerät ("MR-Tomograph").

DISKUSSION DES STANDES DER TECHNIK

Anfang der 1970er Jahre wurde von Paul Lauterbur [1] und Peter Mansfield [2] unabhängig voneinander erkannt, dass mit Hilfe von Gradientenfeldern eine Ortskodierung ermöglicht werden kann. Dieser Entdeckung folgte eine Vielzahl von Erfindungen, die dadurch ermöglicht wurden, dass die Magnetresonanz-Technologie nun auch als bildgebendes Verfahren eingesetzt werden konnte.

Das Grundprinzip der Gradientenkodierung ist hinlänglich bekannt, dargestellt beispielsweise in Referenz [3]. Wenn dem in z-Richtung orientierten konstanten Hauptmagnetfeld ein Magnetfeld (Gradientenfeld) überlagert wird, dessen z-Komponente in einer bestimmten räumlichen Richtung linear variiert, ändert sich die Larmorfrequenz der betroffenen Spins ebenfalls linear in dieser Richtung, so dass durch die Analyse des Frequenzspektrums des aufgenommenen Signals Ortsanteile entlang eben dieser Richtung separiert werden können.

Wird nur ein einziges Gradientenfeld verwendet, kann Ortsinformation nur entlang einer einzigen Raumrichtung rekonstruiert werden. Für die dreidimensionale Untersuchung von Objekten werden daher drei Felder benötigt, die lokal jeweils entlang unterschiedlicher nicht in einer Ebene liegenden Raumrichtungen variieren. In der Regel werden drei global aufeinander orthogonal stehende Gradientenfelder erzeugt, die jeweils entlang der x-, der y-und der z-Richtung linear variieren.

Die einzelnen Gradientenfelder werden durch Gradientenspulen generiert, die zusammengenommen das Gradientenspulensystem (hier auch kurz: Gradientensystem) bilden. Dabei werden vor allem an den Seiten offene, zylinderförmige Gradientensysteme verwende; für offene Tomographen existieren biplanare Gradientensysteme. In dem Stand der Technik beschrieben sind außerdem Gradientensysteme mit komplizierteren Geometrien, die besser an die Form der zu messenden Objekte angepasst sind, so z.B. Referenz [4].

Das Grundmodell für eine zylinderförmige z-Gradientenspule (Longitudinalspule) ist eine Maxwell-Spule, die aus zwei Leiterschleifen entgegen gerichteter Polarität besteht. Das Grundmodell für eine zylinderförmige x- und eine y-Spule (Transversalspule) unterscheidet sich signifikant von dem der z-Spule und wird gebildet durch eine Spule, die aus vier sattelförmigen Teilelementen besteht, abgebildet beispielsweise in Referenz [P2].

Problematisch an solchen Gradientensystemen, bei denen die Longitudinalspule und die Transversalspulen unterschiedliche Designs aufweisen, ist insbesondere, dass die Spulen andere Spezifikationen und somit andere Limitationen bezüglich ihrer eigenen Eigenschaften (z.B. Schaltgeschwindigkeit, erzielbare Gradientenstärke) wie auch bezüglich ihres externen Einflusses (z.B. periphere Nervenstimulation, Wirbelströme) hat. Dies hat einen hohen Konstruktions- und Spezifikationsaufwand zur Folge, steht einer flexiblen Handhabung bei der Messung entgegen und hat Ungenauigkeiten zur Folge, die den diagnostischen Wert von MRT-Aufnahmen nicht optimal zur Geltung bringen können.

Aus diesem Grund wurde in Referenz [P1] ein Gradientensystem vorgeschlagen, bei dem die Unterschiede zwischen allen drei Gradientenspulen reduziert werden. Dies wird dadurch erreicht, dass die drei Spulen keine Gradienten entlang der x-, y- und der z-Achse generieren, sondern entlang dreier schräg im Raum verlaufender Achsen, die durch eine Rotation von 120° um die z-Achse ineinander übergehen. Dies kann beispielsweise dadurch erreicht werden, dass Gradienten entlang folgender (in diesem Fall orthogonaler) Achsen erzeugt werden:

$$\mathbf{e}'_1 = \frac{1}{\sqrt{6}}\begin{pmatrix} 2 \\ 0 \\ \sqrt{2} \end{pmatrix}, \mathbf{e}'_2 = \frac{1}{\sqrt{6}}\begin{pmatrix} -1 \\ \sqrt{3} \\ \sqrt{2} \end{pmatrix}, \mathbf{e}'_3 = \frac{1}{\sqrt{6}}\begin{pmatrix} -1 \\ -\sqrt{3} \\ \sqrt{2} \end{pmatrix}. \qquad [[1]]$$

Diese Achsen bilden einen Verkippungswinkel von $\tan^{-1}(e_l/e_t) = \tan^{-1}(1/\sqrt{2}) =$ gegenüber der Transversalebene ("magic angle") und sind jeweils gegenüber den anderen Achsen um 120° in die eine bzw. in die andere Richtung um die z-Achse rotiert. Anders als bei einem typischen Gradientensystem, bei dem nur eine Symmetrie bezüglich der x- und der y-Spule besteht, besteht bei einem solchen "Magic-Angle"-Gradientensystem eine Symmetrie bezüglich aller drei Spulen, so dass Spulen gebaut werden können, die sich sehr ähnlich sind, so dass die oben angesprochenen Probleme zumindest reduziert werden.

Allerdings sind die in [P1] beschriebenen Spulen mit zylinderförmiger Geometrie nur im Wesentlichen gleich und nicht identisch, so dass die oben beschriebenen Probleme mit der in [P1] offenbarten Erfindung nur teilweise behoben werden können.

Hintergrund ist, dass sich die Leiter einer Gradientenspule eines zylinderförmigen Gradientensystems typischerweise auf einer Zylinderoberfläche mit konstantem Radius befinden, siehe zum Beispiel Referenz [P3]. Ein Gradientensystem besteht somit typischerweise aus drei konzentrischen Schichten leicht unterschiedlicher Radien, wobei jede Schicht die Stromleiter einer der drei Gradientenspulen enthält, so auch bei dem in [P1] konkret beschriebene "Magic-Angle"-Gradientensystem. Aufgrund leicht unterschiedlicher Radien bestehen somit weiterhin Unterschiede bezüglich der einzelnen Gradientenspulen, diese sind somit nur im Wesentlichen gleich und nicht identisch.

Ähnliches gilt auch für herkömmliche Gradientensysteme, welche Gradienten entlang der x-, y- und z-Achse erzeugen. Bei diesen herkömmlichen Gradientensystemen haben nicht nur - aufgrund völlig unterschiedlicher Designs - die Transversalspulen, i.e. x- und y-Spule, im Vergleich zur Longitudinalspule, i.e. z-Spule, unterschiedliche Eigenschaften, sondern, aufgrund der unterschiedlichen Radien, auch die beiden Transversalspulen selbst. Auch diese sind somit nur im Wesentlichen gleich und nicht identisch.

Die Tatsache, dass die Spulen nach dem Stand der Technik nicht identisch konstruiert werden können, zieht ein weiteres Problem nach sich: Aktuell muss jede der drei Spulen für sich unterschiedlich entwickelt werden. Dies hat hohe Forschungs- und Entwicklungskosten zur Folge. Außerdem hat die Andersartigkeit der Spulen einen komplexen und somit teuren Produktionsprozess zur Folge, der zudem eine Reihe von manuellen Arbeitsschritten enthält.

Im Folgenden soll ergänzend beispielhaft Stand der Technik beschrieben werden, der für das Design effizienter Gradientensysteme im Allgemeinen hohe Relevanz hat, und somit auch für die vorliegende Erfindung.

Bei der Konstruktion von Gradientensystemen wird, wie beispielsweise aus Referenz [P2] bekannt, auf eine kräftemäßig ausbalancierte (i.e. kräftemäßig ausgeglichene) Bauweise geachtet. Hinzu kommt, dass zur Vermeidung von Wirbelströmen (eddy currents) Gradientensysteme typischerweise mit Kompensationsspulen ("active shield") ausgestattet werden. Diese Technologie ist schon lange bekannt, zum Beispiel aus Referenz [P4], siehe auch Referenzen [10,11]. Hierzu werden in der Regel drei weitere konzentrische Schichten mit deutlich größeren Radien als die drei inneren Gradientenspulen verwendet. Effizienzsteigerungen können erzielt werden, indem auf den Seitenflanken der zylinderförmigen Geometrie die drei inneren Gradientenspulen mit den jeweils zugehörenden äußeren Kompensationsspulen verdrahtet werden, wie aus Referenz [P5] bekannt, siehe z.B. auch Referenz [12]. Auch könnten - zusätzlich zur Feldkompensation im Außenbereich - möglicherweise 3D Designs von Vorteil sein, bei der Stromleiter in einem ganzen Volumen liegen können und nicht nur auf vorgegebenen Oberflächen (siehe Referenz [9]).

Spulengeometrien werden in der Regel zu dem Zweck optimiert, möglichst effiziente Gradientenfelder zu generieren, wobei gleichzeitig ein möglichst hoher Grad an Linearität gefordert wird, so explizit beispielsweise in Referenz [P6] oder Referenz [P7]. In dieser Hinsicht vorteilhaft sind die standardmäßigen Designs, in denen die Stromleiter entlang der azimutalen Richtung auf der Zylinderoberfläche geschlossen, d.h. nicht unterbrochen sind. In Referenz [P8] ist jedoch ein offenes Design beschrieben, bei dem die zylinderförmigen Spulen in eine obere und eine untere Hälfte aufgetrennt sind, um sie näher an das Untersuchungsobjekt zu bringen. Die in Referenz [P8] beschriebene Erfindung beschäftigt sich mit dem Problem, das durch die in azimutaler Richtung entstehenden Unterbrechungen der Stromleiter entsteht und stellt fest, dass eine solche Unterbrechung ohne signifikante Effizienzverluste möglich ist.

Um das Auffinden erfindungsgemäßer Spulendesigns zu erleichtern, sollen noch kurz systematische Methoden vorgestellt werden, die helfen, leistungsfähige Spulendesigns zu entwickeln. Eine Vielzahl von Methoden ist aus dem Stand der Technik bekannt, mit deren Hilfe leistungsfähigere Spulendesigns als die oben beschriebenen Grundmodelle entwickelt werden können.

Eine Übersicht über den Stand der Technik findet sich in dieser Hinsicht in Referenz [P9]. Es existieren sowohl analytische als auch numerische Methoden. Genannt sei hier beispielhaft die Methode aus Referenz [P10], gut zusammengefasst in Referenz [P8] sowie die Methoden beschrieben in den Referenzen [4] bis [9]. Während anfängliche Methoden (siehe Referenzen [5], [6]) auf spezielle Oberflächengeometrien wie einer Zylinderoberfläche beschränkt waren, ist es bei neueren Methoden (siehe Referenzen [4], [7], [8]) möglich, beliebige Oberflächen für Stromverteilungen vorzugeben, oder sogar dreidimensionale Volumina (siehe Referenz [9]). In der Regel lassen sich sehr gute Designs bestimmen unter Missachtung zeitlicher Phänomene (Biot-Savart-Gesetz, siehe Referenzen [4] bis [7]), es existieren aber auch Methoden, die zeitliche Phänomene mitmodellieren (siehe Referenz [8]).

Beispielhaft sei hier die in Referenz [7] dargestellte Methode kurz vorgestellt. Bei dieser Methode wird in einem ersten Schritt eine *stream function* bestimmt. In einem zweiten Schritt wird, basierend auf dieser *stream function* ein praktisches Fingerprint-Leiterdesign abgeleitet.

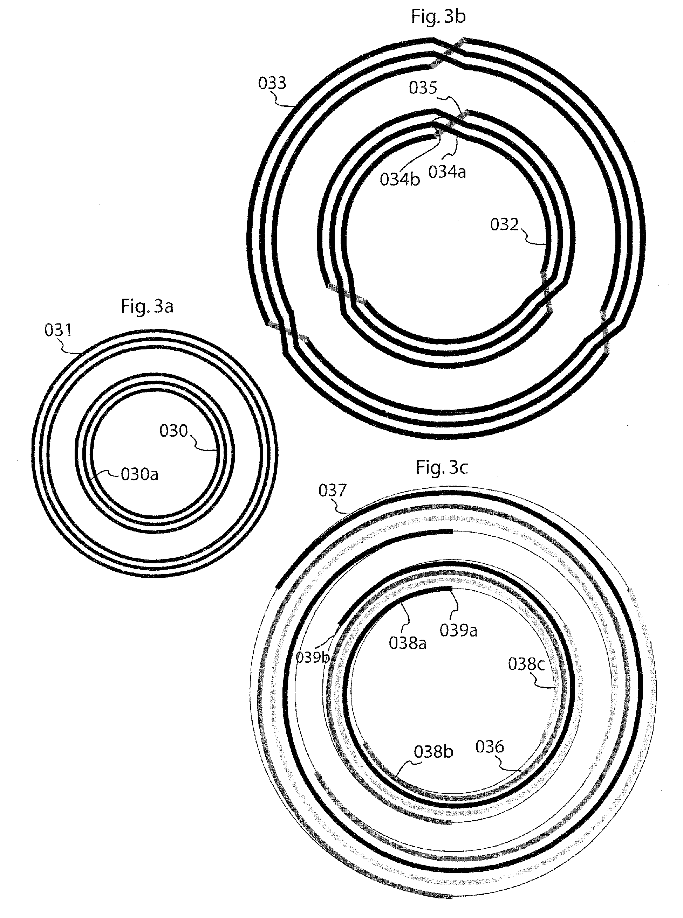

Zur Bestimmung der *stream function* wird folgendermaßen vorgegangen: Als erstes wird eine Spulengeometrie vorgegeben, d.h., es wird eine planare oder gekrümmte Fläche gewählt, auf denen später stromführende Leiter angeordnet werden sollen. Diese Oberfläche kann zum Beispiel ein an den Seiten offener Zylinder sein. Daraufhin wird die Oberfläche mithilfe eines Meshing-Algorithmus in eine große Anzahl von Dreiecken aufgeteilt. Möglich wäre beispielsweise eine Delaunay-Triangulations-Methode. Daraufhin wird an jeder Ecke ("node") eines jeden Dreieckes eine Basisfunktion bestimmt, die allein von der Geometrie des Meshes abhängt. Details finden sich hierzu auf Seite 70 sowie in den Abbildungen 3 bis 5 von Referenz [7], eine Definition der Basisfunktion ist durch Gleichung [[9]] in Referenz [7] gegeben.

Die Stromverteilung auf der Oberfläche ist nun durch eine Linearkombination der Basisfunktionen gegeben, wobei die zugehörigen Gewichte noch zu bestimmen sind. In entsprechender Weise wird nun eine *stream function* als Linearkombination von Basisfunktionen definiert, wobei die Gewichte dieselben sind wie die der Stromverteilung. Dabei wird die *stream function* so definiert, dass der räumliche Gradient der Basisfunktionen gerade die Basisfunktionen der

Stromverteilung ergibt. Die genaue Relation ist durch Gleichung [[6]] in Referenz [7] gegeben. Zur Bestimmung der *stream function* genügt es somit, die Gewichte zu bestimmen. Die Gewichte werden dadurch bestimmt, dass ein geeignetes Optimierungsproblem formuliert und gelöst wird. Die Formulierung des Optimierungsproblems erschöpft sich dabei in der Wahl eines geeigneten Zielfunktionals, beschrieben durch Gleichung [[1]] in Referenz [7]. Dieses enthält einen ersten Term, der die Abweichung von einem vorgegebenen Magnetfeld (typischerweise ein lineares Magnetfeld in x-, y- oder z-Richtung) bestraft, einen zweiten Term, der die magnetische Energie misst (in Referenz [4] wird an dessen statt ein Term, der die Verlustleistung beschreibt, verwendet) sowie einen dritten Term, der mithilfe von Lagrange-Multiplikatoren die Nebenbedingungen enthält, die sicherstellen, dass die gefundene Stromverteilung kräftemäßig ausbalanciert ist (s. Gleichung [[4]] in Referenz [7]).

Nachdem dieses Zielfunktional gewählt ist, besteht das Optimierungsproblem darin, dieses zu minimieren. Hierfür ist das Zielfunktional nach den zu bestimmenden Gewichten und den Lagrange-Multiplikatoren abzuleiten und das Ergebnis ist gleich null zu setzen. Aus dieser Vorgehensweise resultiert ein lineares Gleichungssystem $ZI = b$, bei dem die Matrix $Z$ sowie die rechte Seite $b$ nur von der vorgegebenen Spulengeometrie, dem vorgegebenen Magnetfeld sowie dem sonstigen Zielfunktional abhängt und die gesuchten Gewichte unmittelbar durch Komponenten des Vektors $I$ gegeben sind. Durch Inversion des Gleichungssystems, beispielsweise mittels Gauß-Elimination oder durch Bestimmung der Pseudo-Inversen von $Z$, kann $I$ bestimmt werden. Damit sind die Gewichte der *stream function* bestimmt und somit auch die *stream function* selbst auf der vorgegebenen Fläche.

In einem zweiten Schritt kann nun aus der *stream function* die Lage und Form von Stromleitern abgeleitet werden, die die fertige Spule bilden soll. Ein mögliches Vorgehen ist auf Seite 73 in [7] beschrieben. Es ist bekannt, dass die Konturen der *stream function* das Fingerprint-Design von Spulen bilden. Die Konturen geben somit eine direkte Indikation für den Bau einer Spule, indem - nach Wahl einer frei bestimmbaren Anzahl von Konturlinien - Drähte konstanter Stromstärke entlang der Konturen gelegt werden, bzw. indem aus einer großflächigen Leiterplatte an dem Ort der Konturlinien (oder genau zwischen zwei solchen Linien) leitendes Material entfernt wird.

Es ist dabei allerdings noch darauf zu achten, dass die Konturlinien oftmals geschlossene Linien bilden, so dass an bestimmten Stellen die Konturlinien miteinander verbunden werden sollten, bzw. indem eine wirbeiförmige Linienführung gewählt wird. Die hierzu verwendeten Verfahren sind hinlänglich bekannt, siehe z. B. schon Referenz [P6], angemeldet bereits im Jahr 1983. Ein Beispiel für ein Fingerprint-Design einer Transversalspule (z-Spule) findet sich in Referenz [P6], ein Beispiel für ein Fingerprint-Design einer Longitudinalspule findet sich in Referenz [P4].

ZUSAMMENFASSUNG DER ERFINDUNG

Aufgabe der vorliegenden Erfindung ist es demgegenüber, die oben beschriebenen Probleme aus dem Stand der Technik zu umgehen, die vor allem darauf beruhen, dass die bekannten Gradientensysteme aus Spulen bestehen, die zwar im Wesentlichen ähnlich oder sogar nahezu gleich konstruiert sein mögen, jedoch *keine* konsequent *identische Bauweise* aufweisen.

Diese Aufgabe wird erfindungsgemäß auf ebenso überraschend einfache wie wirkungsvolle Weise dadurch gelöst, dass ein gattungsgemäßes Gradientensystem mit den eingangs definierten Merkmalen zur Verfügung gestellt wird, bei dem entweder alle drei oder aber zumindest zwei der drei Gradientenspulen geometrisch genau identisch aufgebaut sind, was dadurch erreicht wird, dass die Spulen spiralförmig und/oder stufenförmig ausgeformt werden.

BEVORZUGTE AUSFÜHRUNGSFORMEN DER ERFINDUNG

Von Interesse sind insbesondere erfindungsgemäß modifizierte Gradientensysteme für MR-Tomographen mit zylinderförmiger Bohröffnung, d.h. Gradientensysteme, die zylinderförmig ausgeformt sind. Die Verwendung identischer Gradientenspulen setzt voraus, dass die Spulen nicht auf konzentrischen Schalen unterschiedlicher Radien angeordnet sind. Möglich ist aber beispielsweise ein stufenförmiger oder spiralförmiger Aufbau, bei dem die Leiter auch eine radiale Komponente aufweisen. Wird für einen Tomographen ein Gradientensystem verwendet, bei dem drei Gradientenrichtungen erzeugt werden, die durch eine Rotation von 120° ineinander übergehen, so führt eine solche spiralförmige Konstruktion - wie später im Detail beschrieben - zu dem gewünschten Erfolg. Ein ähnliches Prinzip kann auch verwendet werden, um ein Gradientensystem zu konstruieren, welches aus einer Longitudinalspule und zwei um 90° gegeneinander rotierten Transversalspulen identischer Konstruktion besteht.

Von Interesse sind aber auch erfindungsgemäße Spulendesigns für Gradientensysteme, die planar oder biplanar ausgeformt sind, deren Gradientenspulen zwar für sich genommen identisch konstruiert werden können, deren Felder aber nicht identisch sind, da sie herkömmlicherweise auf unterschiedlichen Ebenen zu einem Gradientensystem zusammengefügt werden müssen. Auch hier bietet, wie weiter unten anhand eines konkreten Ausführungsbeispiels gezeigt, ein spiralförmiger Aufbau gemäß der vorliegenden Erfindung Abhilfe.

Aufgrund der nicht mehr exakt zylinderförmigen (respektive planaren) Konstruktion, sondern der stufenförmigen, spiralförmigen oder ähnlichen Verbiegung der Gradientenspulen, sind solche Gradientendesigns am einfachsten zu realisieren, die entlang der azimutalen Richtung offen sind. Effizienter sind hingegen Designs, die die offenen Seiten miteinander vollständig oder zumindest zum Teil verdrahten, d.h. geschlossen oder zumindest halb-geschlossen sind. Einige Ausführungsbeispiele werden hierzu später detailliert aufgeführt.

Neben den soeben angesprochenen erfindungsgemäßen Besonderheiten, die dann unabdinglich sind, wenn eine echte Identität der Spulengeometrien erreicht werden soll, ist es ein großer Vorteil der vorliegenden Erfindung, dass sie sich relativ einfach umsetzen lässt und sich unmittelbar in bestehende Magnetresonanzgeräte integrieren lässt.

So gelten bei dem Auffinden optimaler erfindungsgemäßer Spulendesigns die gleichen Prinzipien, die auch für bestehende Spulendesigns gelten. So sollte beispielsweise in der Regel darauf geachtet werden, dass die Designs kräftemäßig ausbalanciert sind oder beispielsweise auch darauf, dass in der Regel eine aktive Abschirmung des magnetischen Feldes nach außen unter Verwendung von Kompensationsspulen nützlich ist.

Um solche optimalen Designs aufzufinden, kann dem Grunde nach auf die gleichen Methoden zurückgegriffen werden, die dem Fachmann an sich bekannt sind, um auch herkömmliche optimale Spulendesigns aufzufinden. Der Stand der Technik hält insoweit eine Reihe von Möglichkeiten bereit, die Erfindung effektiv umzusetzen.

Aus der erfindungsgemäßen Konstruktionsweise des Gradientensystems ergeben sich zwar einige Besonderheiten, die Grundvoraussetzungen sind jedoch dieselben wie bei herkömmlichen Gradientensystemen. Dies hat zur Folge, dass mit seinem Wissen über den Stand der Technik und mit den in dieser Beschreibung angegebenen Informationen der Fachmann nicht nur dazu in die Lage versetzt wird optimale erfindungsgemäße Spulendesigns aufzufinden; er wird, basierend auf diesen Designs, auch wissen, wie ein geeignetes Gradientensystem konstruiert werden kann und ihm wird bewusst sein, wie er es in ein bestehendes Magnetresonanzgerät integrieren und ansteuern kann, da auch insoweit keine signifikanten Besonderheiten zu herkömmlichen Gradientensystemen bestehen.

Durch die Verwendung identischer Gradientenspulen wird ein Gradientensystem zur Verfügung gestellt, welches zum einen besonders vorteilhafte Eigenschaften hat (beispielsweise bezüglich Wirbelstromkompensation, elektrischer Ansteuerung, Trajektorienstabilität oder Wärmeentwicklung), zum anderen aber auch Vorteile bei der Entwicklung und der Konstruktion und somit Potential für Kostenersparnisse bietet. So genügt es, lediglich ein optimales Design für mehrere Spulen zu entwickeln. Ein spiralförmiger Aufbau erlaubt es darüber hinaus, beispielsweise die einzelnen Leiterplatten der Gradientenspulen versetzt nebeneinander zu legen und auf einfache Weise in einem einzigen Produktionsschritt um ein vorgefertigtes zylinderförmiges Montageelement zu wickeln.

In den Rahmen der vorliegenden Erfindung fällt somit insbesondere ein Gradientensystem für die Magnetresonanzbildgebung, das drei Gradientenspulen umfasst, welche

    a. stromführende Leiter aufweisen, die auf planaren oder gekrümmten Flächen angeordnet sind, wobei die stromführenden Leiter von n der drei Gradientenspulen, mit n=2 oder n=3, in azimutaler Richtung geschlossen, halbgeschlossen oder offen ausgeformt sind und
    b. jeweils ein magnetisches Gradientenfeld erzeugen, wobei die Gradientenrichtungen orthogonal zueinander sind,

dadurch gekennzeichnet,
dass die planaren oder gekrümmten Flächen der n Gradientenspulen spiralförmig und/oder stufenförmig ausgeformt sind, und dass die stromführenden Leiter der n Gradientenspulen identisch ausgeformt sind.

Hierbei ist zu beachten, dass die Anordnung auf Flächen bedeutet, dass die Leiter in geometrischer Hinsicht auf Oberflächen angeordnet sind. Eine planare Oberfläche kann durch (gedachtes) Verbiegen einer ebenen Fläche eine leichte Krümmung aufweisen (s. unten). Insoweit wird sprachlich auf die Referenzfläche vor (gedachter) Modifikation abgestellt. Von Bedeutung sind insbesondere Ausführungsformen, bei denen die Gradientenspulen jeweils ein lineares magnetisches Gradientenfeld erzeugen.

In einer präferierten Ausführungsform ist das Gradientensystem dadurch gekennzeichnet, dass die n identischen Gradientenspulen ineinander überführt werden, wenn das Gradientensystem um eine z-Achse des Gradientensystems im Fall von n = 2 um einen Winkel $\alpha1$ = 90° oder im Fall von n = 3 um einen Winkel $\alpha2$=120° rotiert wird, unabhängig davon, ob in die eine oder die andere Richtung rotiert wird, das Gradientensystem somit hinsichtlich der n identischen Gradientenspulen im Fall von n = 2 eine 90°-Symmetrie oder im Fall von n = 3 eine 120°-Symmetrie aufweist.

Hierbei ist zu beachten, dass mit identischen Gradientenspulen gemeint ist, dass die stromführenden Leiter dieser Gradientenspulen identisch sind. Der Term "die n identischen Gradientenspulen" kann somit ersetzt werden durch "die identisch ausgeformten stromführenden Leiter der n Gradientenspulen" oder durch eine ähnliche Formulierung. Außerdem ist zu beachten, dass die 90°-Symmetrie bzw. die 120°-Symmetrie bezüglich der Rotationsachse (hier als "eine z-Achse des Gradientensystems" bezeichnet) besteht. In anderen Worten sind die stromführenden Leiter von den n der drei Gradientenspulen identisch ausgeformt, wenn sie im Fall von n = 2 um einen Winkel $\alpha1$ = 90° oder im Fall von n = 3 um einen Winkel $\alpha2$ =120° um eine z-Achse des Gradientensystems rotiert werden, unabhängig davon, ob in die eine oder die andere Richtung rotiert wird. Außerdem ist zu beachten, dass mit "einer z-Achse" nicht unbedingt die z-Achse eines kartesischen Koordinatensystems gemeint ist, sondern eine bestimmte Raumrichtung. Bei einer zylinderförmig ausgeformten Geometrie entspricht die z-Achse der Zylinderachse, bei einer planaren Geometrie der Richtung, die orthogonal zu der planaren Geometrie orientiert ist (s. unten).

Erfindungsgemäß ist auch ein Gradientensystem, das dadurch gekennzeichnet ist, dass es zylinderförmig ausgeformt ist und dass die z-Achse der Zylinderachse, i.e. der Längsachse des zylinderförmig ausgeformten Gradientensystems, entspricht.

In einer vorteilhaften Ausführung ist das zylinderförmig ausgeformte Gradientensystem dadurch gekennzeichnet, dass n = 3 und $\alpha2$ = 120°, und dass die Ausdehnung der n Gradientenspulen in azimutaler Richtung 360° beträgt, wobei mit azimutaler Richtung die (in kartesischen Koordinaten sich verändernde) Richtung auf der zylinderförmig ausgeformten Oberfläche um die Zylindergeometrie herum gemeint ist.

In einer weiteren vorteilhaften Ausführung ist das zylinderförmig ausgeformte Gradientensystem dadurch gekennzeichnet, dass n = 3 und $\alpha2$ = 120°, und dass die Ausdehnung der n Gradientenspulen in azimutaler Richtung mehr als 360° beträgt $\alpha2$ = 120°.

Von besonderem Interesse ist auch ein zylinderförmig ausgeformtes Gradientensystem, das dadurch gekennzeichnet ist, dass n = 2 und $\alpha1$ = 90°, und dass die n = 2 identischen Gradientenspulen Transversalspulen bilden, die orthogonale Gradientenfelder in der Transversalebene der zylinderförmigen Geometrie des Gradientensystems erzeugen und die dritte Gradientenspule als Longitudinalspule ausgebildet ist, und wobei die zwei Transversalspulen in azimutaler Richtung offen ausgeformt sind.

Hierbei meint die offene Ausformung der Transversalspulen, dass die stromführenden Leiter offen ausgeformt sind. Auch eine geschlossene oder eine halb-geschlossene Ausformung kann sinnvoll sein. Die Gradientenfelder sind per definitionem lineare Gradientenfelder.

In einer präferierten Ausführungsform ist das zylinderförmig ausgeformte Gradientensystem mit n = 2 identischen Transversalspulen dadurch gekennzeichnet, dass jede Transversalspule aus zwei Elementen besteht, die jeweils in azimutaler Richtung eine Ausdehnung von 180° haben und um 180° gegeneinander rotiert sind, wobei jedes Element selbst

    c. offen,

    d. spiralförmig oder

    e. stufenförmig mit einer Stufe in der Mitte zwischen 0° und 180° ausgestaltet ist.

Die Erfindung erstreckt sich auch auf ein Gradientensystem, das dadurch gekennzeichnet ist, dass es planar oder biplanar ausgeformt ist, und dass die z-Achse derjenigen Achse entspricht, die orthogonal zu den planaren oder biplanaren Leiteroberflächen orientiert ist.

Wie oben schon angedeutet und unten genauer ausgeführt, wird im Rahmen dieser Erfindung ein Gradientensystem, welches aus im Wesentlichen planaren Gradientenspulen aufgebaut ist, als planar (bzw. biplanar) bezeichnet. Auch Gradientenspulen, die durch (gedachte) geringfügige Verbiegung aus einer exakt ebenen Spule hervorgehen, werden in diesem Zusammenhang nicht als "im Wesentlichen planar", sondern schlicht als "planar" bezeichnet (bzw. biplanar). Die z-Achse ist bei einer im Wesentlichen biplanaren Gradientenspule diejenige, die durch die kürzeste Verbindung der beiden Teilspulen bestimmt wird. Wird im Rahmen dieser Erfindung von einem Azimutalwinkel in Bezug auf planare oder biplanare Gradientensysteme gesprochen, so ist hiermit der Rotationswinkel in Bezug auf diese z-Achse gemeint.

Eine vorteilhafte Ausführungsform eines planaren oder biplanaren Gradientensystems ist dadurch gekennzeichnet, dass n = 3 und $\alpha2$ = 120°.

In einer weiteren vorteilhaften Ausführung ist das planare oder biplanare Gradientensystem dadurch gekennzeichnet, dass n = 2 und $\alpha 1$ = 90° beträgt, und dass die n = 2 identischen Gradientenspulen Transversalspulen bilden, die orthogonale Gradientenfelder in der Transversalebene der planaren oder biplanaren Geometrie des Gradientensystems erzeugen, und die dritte Gradientenspule als Longitudinalspule ausgebildet ist.

Die oben für eine zylinderförmige Ausformung eines Gradientensystems genannten vorteilhaften Ausführungsformen haben jeweils eine Entsprechung bei planarer Ausformung. Diese entsprechenden planaren Ausführungsformen sind ebenfalls vorteilhafte Ausprägungen dieser Erfindung.

Zu beachten ist, dass alle vorteilhaften Ausführungen der erfindungsgemäßen Gradientensysteme so ausgestaltet sein können, dass die drei Hauptgradientenspulen durch Kompensationsspulen für eine aktive Abschirmung der magnetischen Felder nach außen ergänzt sind.

Insbesondere wird es in einer Reihe von praktischen Anwendungen der erfindungsgemäßen Gradientensysteme nützlich sein, wenn die verwendeten Gradientenspulen kräftemäßig ausbalanciert sind.

Die vorliegende Erfindung bezieht sich nicht nur auf Gradientensysteme, sondern auch auf Gradientenspulen, die in einem solchen erfindungsgemäßen Gradientensystem verwendet werden.

Insbesondere fällt in den Rahmen der vorliegenden Erfindung auch eine Gradientenspule zur Verwendung in einem erfindungsgemäßen Gradientensystem der oben beschriebenen Art, wobei die Gradientenspule stromführende Leiter aufweist, die auf einer planaren oder gekrümmten Fläche angeordnet und in azimutaler Richtung geschlossen, halb-geschlossen oder offen ausgeformt sind, und wobei die Gradientenspule aus einem oder aus zwei Elementen aufgebaut ist und, sofern die Gradientenspule aus einem Element besteht, eine Ausdehnung in azimutaler Richtung von 360° oder mehr hat oder, sofern die Gradientenspule aus zwei Elementen besteht, jedes Element eine Ausdehnung in azimutaler Richtung von 180° hat,

dadurch gekennzeichnet,

dass jedes Element spiralförmig und/oder stufenförmig ausgeformt ist.

Im Fall, dass die Gradientenspule aus zwei Elementen besteht, ist es vorteilhaft, wenn die stufenförmige Ausgestaltung der Elemente eine Stufe in der Mitte zwischen 0° und 180° hat. Von besonderem Interesse sind (im Wesentlichen) zylinderförmig oder (im Wesentlichen) planar ausgeformte Gradientenspulen. Zu beachten ist auch, dass aus der Tatsache, dass die Gradientenspule in einem erfindungsgemäßen Gradientensystem verwendet werden soll, konstruktive Besonderheiten bestehen. So müssen die Elemente in der Art spiralförmig und/oder stufenförmig ausgeformt sein, dass n=(2-1) oder n=(3-1) weitere identische Gradientenspulen zu einem Gradientensystem angeordnet werden können. Dies bedeutet insbesondere, dass ein "Ineinanderverschachteln" möglich sein muss. In anderen Worten ist eine erfindungsgemäße Gradientenspule dadurch gekennzeichnet, dass bei gedachtem (n-1)-fachem identischen Nachbau der Spule, mit n = 2 oder n = 3, die Flächen, auf denen die stromführenden Leiter der n Spulen angeordnet sind, sich nicht durchdringen. Dabei ist zu beachten, dass die Flächen von stromführenden Leitern nicht bloß gedachte Flächen ohne Ausdehnung sind, sondern dass diese Flächen eine reale Dicke haben, die von der Dicke der verwendeten stromführenden Leiter und deren Isolierungen abhängt. Dieser Bereich beträgt in aller Regel nicht weniger als einen Millimeter und nicht mehr als einen oder wenige Zentimeter, je nach Größe und Leistungsfähigkeit der der Spule. Dem Fachmann ist bewusst, welche Dicke konkret realisiert werden sollte.

Von Interesse sind nach den obigen Ausführungen solche Gradientenspulen, bei denen keine Durchdringung der Flächen stattfindet, wenn die Gradientenspule und die n gedachten identisch nachgebauten Gradientenspulen ein Gradientensystem im Sinne dieser Erfindung bilden. Dies bedeutet beispielsweise, dass die Gradientenspule dadurch gekennzeichnet ist, dass kein Durchdringen der Flächen stattfindet bei einem Gradientensystem, welches aus der Gradientenspule und den gedachten identisch nachgebauten Gradientenspulen gebildet wird, das dadurch gekennzeichnet ist, dass die n identischen Gradientenspulen ineinander überführt werden, wenn das Gradientensystem um eine z-Achse des Gradientensystems im Fall von n = 2 um einen Winkel $\alpha 1$ = 90° oder im Fall von n = 3 um einen Winkel $\alpha 2$ =120° rotiert wird, unabhängig davon, ob in die eine oder die andere Richtung rotiert wird, das Gradientensystem somit hinsichtlich der n identischen Gradientenspulen im Fall von n = 2 eine 90°-Symmetrie oder im Fall von n = 3 eine 120°-Symmetrie aufweist. In Bezug auf eine Gradientenspule im Sinne dieser Erfindung gilt Entsprechendes auch für die anderen oben beschriebenen Ausführungsformen eines erfindungsgemäßen Gradientensystems.

Weitere Vorteile der Erfindung ergeben sich aus der Detailbeschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

KURZBESCHREIBUNG DER ZEICHNUNG

Die im Folgenden kurz erläuterten Figuren der Zeichnung dienen der Veranschaulichung von beispielhaften Ausführungsformen der Erfindung. Außerdem sollen sie verdeutlichen, wie die Erfindung ausgeführt werden kann und illustrieren teilweise Probleme, für die in der detaillierten Beschreibung Lösungen bereitgestellt werden.

Die Erfindung ist in der Zeichnung dargestellt und wird anhand von Ausführungsbeispielen näher erläutert.

**Fig. 1** stellt ein optimiertes Fingerprint-Design sowie eine passende mögliche Anordnung von Stromleitern für eine zylinderförmige Gradientenspule mit offenen seitlichen Enden, aber geschlossenen Leiterplatten entlang der azimutalen Richtung dar; die Spule erzeugt einen Feldgradienten mit Transversal- wie auch mit Longitudinalkomponente.

**Fig. 2** stellt ein optimiertes Fingerprint-Design für eine erfindungsgemäße spiralförmige Spule dar mit offenen seitlichen Enden und nicht-geschlossenen (i.e. offenen) Leiterplatten entlang der azimutalen Richtung.

**Fig. 3** zeigt einen bekannten schalenförmigen Aufbau eines Gradientensystems mit Kompensationsspulen in Seitenansicht sowie zwei verschiedene mögliche Anordnungen eines erfindungsgemäßen Gradientensystems.

**Fig. 4** zeigt ein offenes spiralförmiges Design, welches nicht wie die Designs der Fig. 1 und Fig. 2 kräftemäßig ausbalanciert ist und gibt Aufschluss darüber, welche Geometrie die Kompensationsströme für dieses Design haben müssen, um effektiv die gleiche kräftemäßig ausbalancierte Gesamtgeometrie aufzuweisen wie das in Fig. 1 dargestellte Design.

**Fig. 5** zeigt beispielhaft eine Leiterschleife für drei verschiedene Konstruktionen und veranschaulicht, dass es möglich ist, auf einfache Weise kräftemäßig ausbalancierte offene Spulendesigns zu entwickeln, wenn die Spule einen Winkel von etwas mehr als 360° entlang der azimutalen Richtung einschließt.

**Fig. 6** illustriert das Problem, dass bei geschlossenen erfindungsgemäßen Designs verbindende Stromleiter einer Gradientenspule die Leiterplatten der zwei anderen Gradientenspulen passieren müssen. Die Abbildung dient der Veranschaulichung für Lösungen, die im Text ausführlich beschrieben sind.

**Fig. 7** illustriert ein Fingerprint-Design einer herkömmlichen Transversalspule sowie zwei erfindungsgemäße Varianten eines Gradientensystems, bei dem die x- und die y-Spule völlig identisch ausgestaltet sind.

**Fig. 8** illustriert die Oberfläche einer Gradientenspule für ein erfindungsgemäßes planares Gradientensystem, bzw. die Oberfläche des oberen oder unteren Teils einer Gradientenspule für ein biplanares Gradientensystem.

DETAILLIERTE BESCHREIBUNG DER ERFINDUNG

Im Folgenden werden erfindungsrelevante Grundlagen sowie spezifische Ausführungsformen der Erfindung detailliert beschrieben, wobei teilweise auf die Zeichnungen Bezug genommen wird. Die Erfindung soll jedoch nicht auf diese spezifischen Ausführungsformen beschränkt sein.

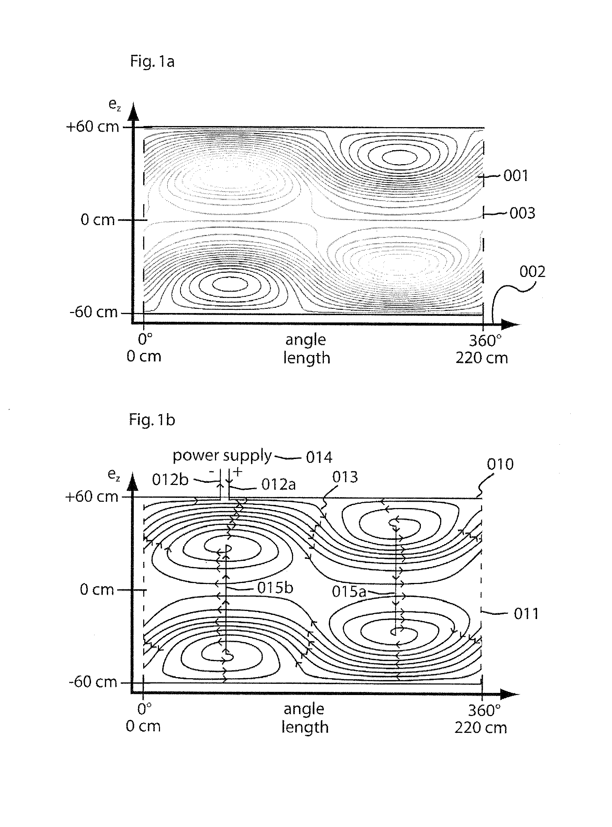

**Fig. 1** stellt ein optimiertes Fingerprint-Design (Fig. 1a, 001) sowie eine passende mögliche Anordnung von Stromleitern (Fig. 1b, 013) für eine zylinderförmige Gradientensystem mit offenen seitlichen Enden, aber geschlossenen Leiterplatten entlang der azimutalen Richtung 002 dar; die gestrichelt gezeichneten Linien **003, 011** deuten an, dass es sich um eine geschlossene Geometrie handelt, so dass Konturlinien und Stromleiter, die auf einer Seite des Bildes austreten, auf der anderen Seite wieder auftauchen. Das in Fig. 1 dargestellte Design ist ein optimiertes Resultat, das zu einem wie in Fig. 3a gezeigten Gradientensystem mit schalenförmigem Aufbau (ohne Kompensationsspulen) gehört. Die englischen Begriffe "angle", "length", "radius" und "power supply" in den Zeichnungen bedeuten "Winkel", "Länge", "Radius" und "Stromquelle".

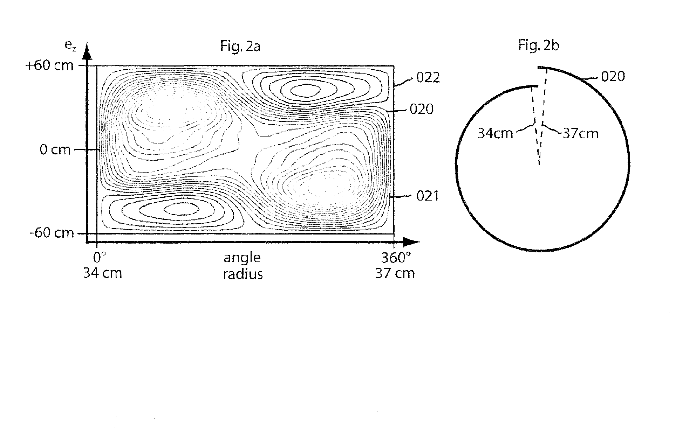

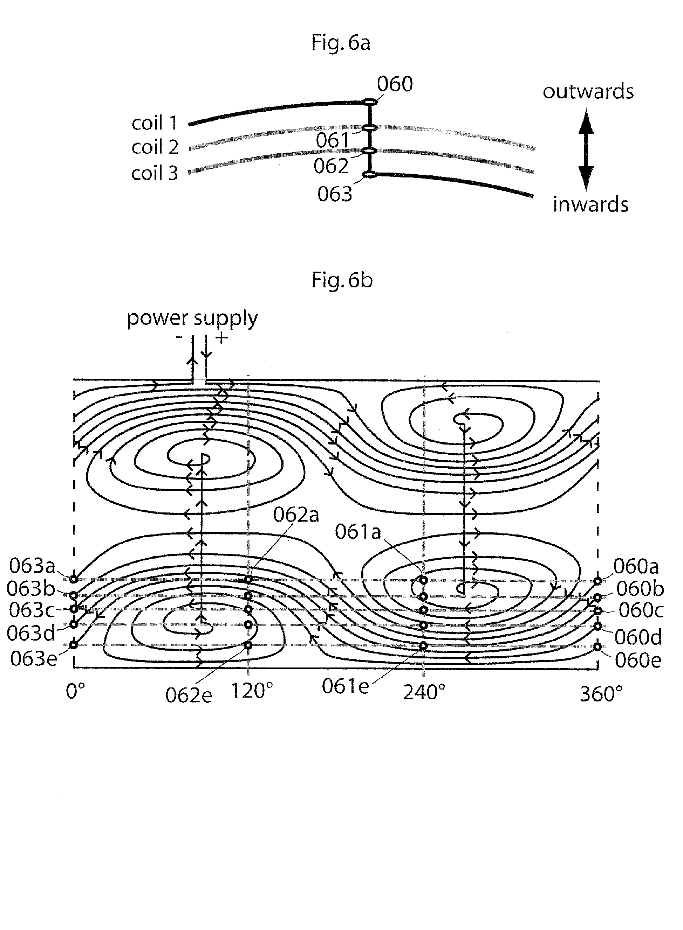

Auch wenn der in Fig. 3a gezeigte schalenförmige Aufbau zum Stand der Technik gehört, ist dieses Beispiel dennoch interessant für die vorliegende Erfindung, da dieses oder zumindest ein ähnliches Design für das geschlossene, erfindungsgemäße, in Fig. 3b dargestellte Design verwendet werden kann, s. ausführlicher hierzu unten in dem Abschnitt vor der detaillierten Beschreibung von Fig. 2. Das Design **001** erzeugt einen Feldgradienten mit Transversal- wie auch mit Longitudinalkomponente mit einem Verkippungswinkel von 45° zur Transversalebene entlang einer Richtung, die hier mit e bezeichnet wird. Möglich ist beispielsweise auch ein Winkel von 35,26° (magic angle); dies ist, wie später noch gezeigt, sogar nützlich für die vorliegende Erfindung, da ein solcher Winkel zu einem orthogonalen Kodiersystem führt und weniger Wicklungen um die zylinderförmige Geometrie nötig macht (s. unten der zweite Abschnitt der detaillierten Beschreibung zu Fig. 6).

Das in Fig. 1 gezeigte Design liegt auf einem geschlossenen Zylinder mit einem Radius von 35cm. Durch Rotation von $\pm 120°$ und Optimierung für zwei leicht unterschiedliche Radien ergäben sich nicht identische, doch ähnliche Designs, die für ein Gradientensystem verwendet werden könnten, wie es in [P1] = EP 1 122 552 B1 beschrieben ist. Es fällt auf, dass das Design sowohl Elemente einer Longitudinalspule (parallele Wicklungen um den Spulenkörper) aufweist als auch Elemente einer Transversalspule (vier wirbelförmige Spulenelemente), was der Tatsache geschuldet ist, dass die Kodierachse sowohl eine Transversal- als auch eine Longitudinalkomponente hat. Die Oberfläche des Designs hat eine Ausdehnung in z-Richtung von -60 cm bis 60 cm, die Stromverteilung erstreckt sich somit über eine Distanz von 120 cm in z-Richtung.

Das in Fig. 1 gezeigte Design wurde berechnet, indem im Wesentlichen der in [7] beschriebenen Methode gefolgt wurde, indem allerdings auch Elemente aus [4] und [8] verwendet wurden. Zunächst wurde die zylinderförmig gekrümmte Fläche der Spule, auf der die stromführenden Leiter angeordnet sind, durch die z-Koordinate und den Azimutalwinkel $\theta$ parametrisiert, d.h. die Oberfläche für das Design **001** wurde dargestellt durch

$S = \{\mathbf{x}(\theta,z) \in \mathbb{R}^3 \mid \theta = [0°, 360°]$, z = [-60 cm, 60 cm]}, wobei $x(\theta, z) = r_0 \cos \theta$, $y(\theta, z) = r_0 \sin \theta$ und $z(\theta, z) = z$, wobei $r_0 = 35$cm gewählt wurde.

Daraufhin wurde diese Fläche im parametrisierten Raum trianguliert. Dazu wurde die $\theta$-z-Ebene zunächst in regelmäßige Vierecke aufgeteilt, die dann jeweils noch einmal geteilt wurden, so dass aus jedem Viereck zwei Dreiecke erzeugt wurden. Insgesamt wurden 2880 Dreiecke erzeugt. Dabei wurde wegen der Geschlossenheit des Designs (i.e. der Geschlossenheit der stromführenden Leiter) darauf geachtet, dass Dreiecke in azimutaler Richtung keine Berandung haben, sondern auch bei 0° miteinander in Verbindung stehen.

Als nächstes wurde eine *stream function* $\Psi = \Sigma_i I_i \varphi_i$ mit Gewichten $I_i$ und Basisfunktionen $\varphi_i$ generiert, wobei jedoch nicht die in [7] dargestellten Basisfunktionen gewählt wurden, sondern sogenannte, dem Fachmann bekannte, "triangular linear shape functions". Sei $\mathbf{j}$ definiert als die Stromdichte. Nun ist $\mathbf{j} = \nabla \times (\Psi\mathbf{n})$, wobei $\mathbf{n}$ der Normalenvektor zur Oberfläche ist; aufgrund dieser Beziehung wurde die Stromdichte mithilfe der Definition der *stream function* berechnet.

Als nächstes wurde das Zielfunktional $\Phi = \sum_{k=1}^{K} [B_z(\mathbf{x}_k) - B_z^t(\mathbf{x}_k)]^2 + \alpha P + \lambda \mathbf{M}$ gewählt. Dabei bedeutet $B_Z$ die Magnetfeldstärke, die mit Hilfe des Biot-Savart-Gesetzes auf Grundlage von $\mathbf{j}$ berechnet werden kann.

$B_z^t$ stellt das zu approximierende Magnetfeld dar, welches durch B(x) = Gx = Gex gegeben ist, wobei $G$ die Stärke des Magnetfeldgradienten (=Gradientenstärke) bezeichnet.

Die Abweichung von gewolltem und tatsächlichem Magnetfeld wird in einer ROI (region of interest) bestimmt, indem K äquidistante Punkte $\mathbf{x}_k$ gewählt werden, die alle innerhalb des ROIs liegen und dieses ausfüllen. Für die Berechnungen wurde ein kugelförmiges ROI mit einem Radius von $r_{ROI}$ = 20cm gewählt und $K$ = 1000. P beschreibt die Verlustleistung, die durch Gleichung [[2]] in [4] gegeben ist und unmittelbar mit der Oberflächengeometrie und der Stromverteilung zusammenhängt.

$\alpha$ ist ein Parameter, der einen Trade-off zwischen Feldlinearität darstellt und Minimierung der Verlustleistung. Dieser Parameter wurde so gewählt, dass die größte Abweichung von der Linearität 5% $\pm$ 0.01% betrug. Dabei wurde die Abweichung dadurch bestimmt, dass die maximale Differenz von gewollter und tatsächlicher Magnetfeldstärke innerhalb des ROIs mit der maximalen gewollten Magnetfeldstärke innerhalb des ROIs durch Division der beiden Werte in Beziehung gesetzt wurde.

Die vektorielle Größe λ beschreibt Lagrange-Multiplikatoren und **M** die drei Komponenten des Drehmomentes wie in den Gleichungen [[19-21]] von [7] definiert. Mit Hinzunahme dieses dritten Termes wurde somit sichergestellt, dass die resultierende Gradientenspule kräftemäßig ausbalanciert ist.

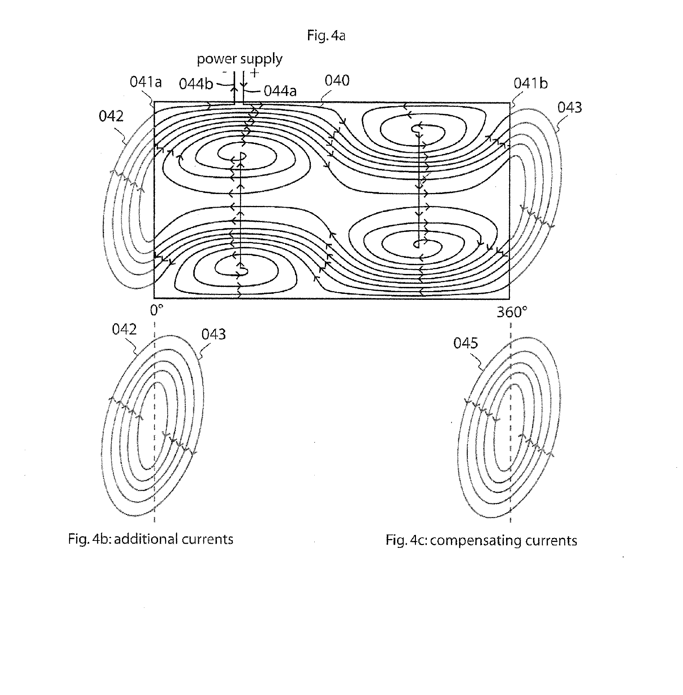

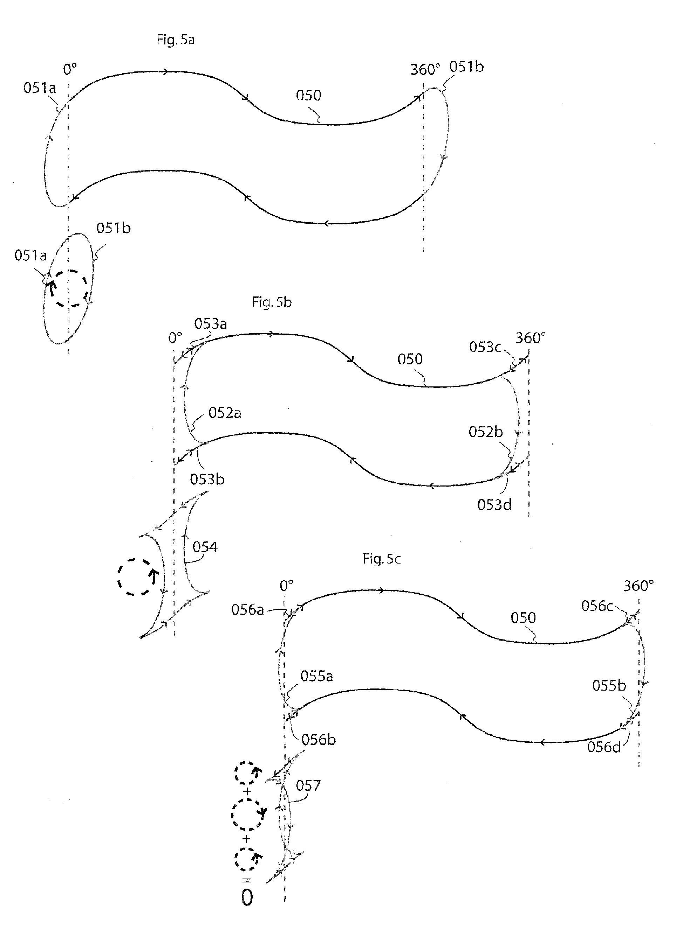

Das weitere Vorgehen unterschied sich nicht von dem in [7] beschriebenen und schon bei der Beschreibung des Standes der Technik repetierten Verfahren. Dabei wurde zur Lösung des resultierenden Gleichungssystems der "\"-Operator von Matlab (The MathWorks, Natick, MA) verwendet. Es soll jedoch betont werden, dass diese Erfindung nicht auf Gradientenspulen beschränkt ist, die durch die hier verwendete Methode gefunden werden können. Jede Methode kann verwendet werden, es kommt allein darauf an, dass die resultierenden Felder einen Gradienten entlang der Richtung e erzeugen. Selbst eine rein intuitive Herangehensweise kann zu aussagekräftigen Anordnungen von Stromleitern einer Gradientenspule führen (so wurden beispielsweise die die oberen mit den unteren Stromleitern verbindenden Stromleiter in Fig. 4 und Fig. 5 nicht mit Hilfe dieser numerischen Methode gefunden, sondern aufgrund anderweitiger Überlegungen).

Das in Fig. 1 dargestellte kräftemäßig ausbalancierte Design hat folgende Eigenschaften: Gradientenstärke von Design **001**: $86 \frac{\mu\mathrm{T}}{\mathrm{m}\cdot\mathrm{A}}$. Widerstand 26 $m\Omega$ bei 26 den Konturlinien der *stream function* folgenden Leitern mit einer Leiterdicke von 3mm und der Leitfähigkeit von Kupfer (6 · 10⁷ m⁻¹Ω⁻¹).

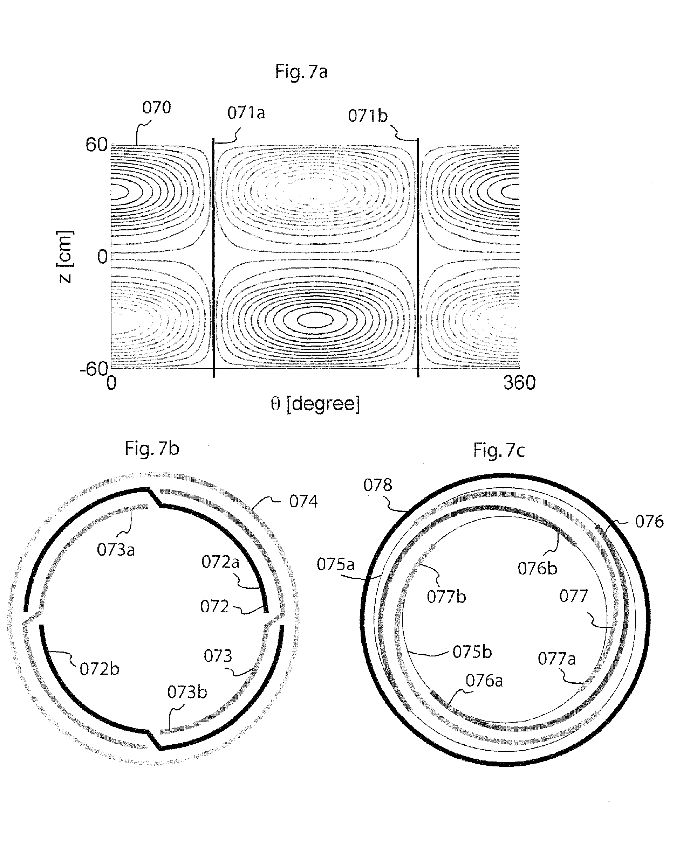

Die im letzten Abschnitt erörterte Methode wurde auch verwendet, um Stromverteilungen für eine Transversal- und eine Longitudinalspule mit einem Radius von 35cm zu finden (die Stromverteilung der Transversalspule ist in Fig. 7a abgebildet). Diese hatten folgende Eigenschaften:

Gradientenstärke der Longitudinalspule/Transversalspule: $135/67 \frac{\mu\mathrm{T}}{\mathrm{m}\cdot\mathrm{A}}$; Widerstand: 40/21 $m\Omega$.

Der Vergleich der Werte zeigt, dass die Spule mit schräger Kodierrichtung Eigenschaften hat, die zwischen denen liegen, die herkömmliche Transversal-und Longitudinalspulen aufweisen, was der Tatsache geschuldet ist, dass die Kodierrichtung einen Anteil entlang der Longitudinalachse aufweist sowie einen, der in der Transversalebene liegt. So ist das in Fig. 1 dargestellte Design effizienter als das Design einer herkömmlichen Transversalspule, jedoch weniger effizient als das einer typischen Longitudinalspule.

**Fig. 1b** zeigt eine zu Fig. 1a passende mögliche praktische Anordnung von Stromleitern, die eine gekrümmte zylinderförmige Fläche bilden mit Berandung 010. Die gestrichelte Linie 011 soll andeuten, dass es sich um eine geschlossene Geometrie handelt, so dass Stromleiter, die auf einer Seite des Bildes austreten, auf der anderen Seite wieder auftauchen; die stromführenden Leiter 013 sind somit geschlossen ausgeformt. Über einen stromzuführenden Leiter 012a ist der stromführende Leiter 013 auf der Zylinderoberfläche mit einer Stromquelle 014 verbunden (wird die Stromquelle umgepolt, ändert sich selbstverständlich die Stromrichtung und aus dem stromzuführenden Leiter wird ein stroma*bf*ührender Leiter und vice versa).

Der Strom fließt zunächst zum ersten Wirbel, der linksdrehend den Strom in immer kleiner werdenden Wicklungen befördert. In der Mitte verlässt der Strom den Wirbel über eine entlang der negativen z-Achse gerade Leiterbrücke **015a** (und daher ohne effektiven Beitrag zum Gradientenfeld) und fließt in den zweiten Wirbel, der sich nach außen dreht und rechtsdrehend ist. Nach einigen wirbeiförmigen Windungen verlässt der Strom den Wirbel in die negative azimutale Richtung und windet sich mehrfach um die Zylindergeometrie. Die sich anschließende Leiteranordnung mit Wirbel, Leiterbrücke **015b,** Wirbel und Wicklungen entspricht der soeben beschriebenen Anordnung, jedoch in $\theta$ - $z$ -Koordinaten um 180° verdreht. Der Strom verlässt die Zylindergeometrie in der Nähe des stromzuführenden Leiters **012a** über einen stromabführenden Leiter **012b,** der für einen geschlossenen Stromkreis über die Stromquelle **014** sorgt.

Die in Fig. 1b gezeichnete Stromleiteranordnung wurde auf Grundlage von den in Fig. 1a gezeigten Konturlinien der *stream function* erstellt. Möglich wäre es zwar, Stromleiter so anzuordnen, dass sie den Konturlinien unmittelbar folgen, allerdings bietet eine solche Anordnung Schwierigkeiten bei der Versorgung der Leiter mit Strom. Daher ist es üblich, Verbindungen zwischen den Konturlinien herzustellen. Dies kann zum Beispiel abrupt mit Hilfe kurzer Leiterbrücken geschehen (s. z.B. Referenz [P4]), oder aber kontinuierlich (s. z.B. Referenz [P6]). Fig. 1b zeigt eine Anordnung der zweiten Kategorie, so dass sich ein wirbelförmiges Design ergibt (in der gezeigten Anordnung haben die Leiter einen durchschnittlichen Abstand von zwei in Fig. 1a gezeigten Konturlinien).

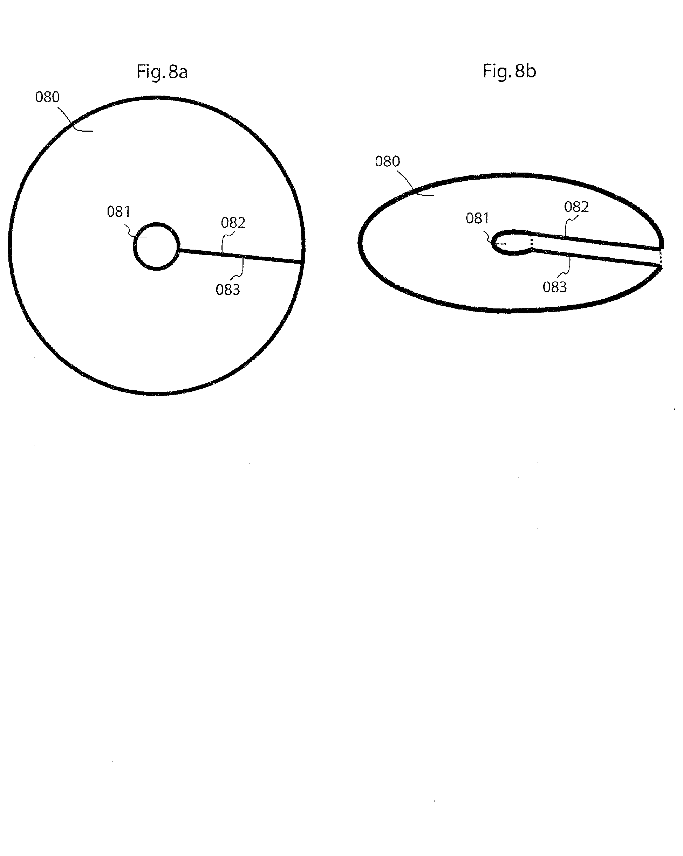

Diese in Fig. 1b gezeigte Anordnung ist selbstverständlich nur eines von vielen möglichen Beispielen, wie aus einem *stream function*-Design eine nützliche Anordnung von Stromleitern abgeleitet werden kann. Dem Fachmann sind unterschiedliche Methoden bekannt, wie zum Beispiel die soeben angesprochenen zwei Herangehensweisen (s. z.B. [P10] = US 5 309 107 A, Fig. 7,8). Auch hat der Fachmann ausreichende Kenntnis darüber, wie er, basierend auf einer gefunden Verteilung von stromführenden Leitern, die vollständige Gradientenspule konstruieren würde und wie er sie ansteuern würde. So wird der Fachmann beispielsweise wissen, welchen Querschnitt die Leiter optimaler Weise haben sollten oder wie die Leiter fixiert, gekühlt und isoliert werden sollten. Der Fachmann kennt auch Methoden, die ihn dazu befähigen, beispielsweise auf die in Fig. 1b gezeigten Leiterbrücken **015a,b** verzichten zu können, indem er die Spule zweilagig konstruiert, siehe beispielsweise in [13]. Auch wird er die Geometrie der Strom zu- und abführenden Leiter nach den Anforderungen gestalten, die sich ihm stellen. Die in Fig. 1b dargestellten Leiter **012a, 012b** stellen nur ein mögliches Ausführungsbeispiel dar.

Erfindungsgemäße Stromverteilungen bzw. Anordnungen von stromführenden Leitern unterscheiden sich zwar in ihrer konkreten Geometrie (d.h. in der Fläche, auf der die Stromleiter angeordnet sind) von bisher existierenden Designs. Das in Fig. 2 gezeigte und in dem Abschnitt der detaillierten Beschreibung zu Fig. 2 besprochene Beispiel sowie die unten in dem Abschnitt vor der detaillierten Beschreibung von Fig. 2 angestellten Überlegungen zur erfindungsgemäßen Verwendung von dem in Fig. 1 dargestellten Design zeigen jedoch, dass die Unterschiede nicht so groß sind, dass nicht herkömmliche Methoden verwendet werden könnten, um aus einer *stream function* oder einer Anordnung von stromführenden Leitern eine Gradientenspule sowie ein vollständiges Gradientensystem zu konstruieren und dieses in einen bestehenden MR-Tomographen einzufügen.

Der Fachmann wird daher im Rahmen dieser Erfindung in der Regel auf bereits bekannte Methoden zurückgreifen können. Insbesondere gelten die zu Fig. 1 erläuterten Details im Wesentlichen auch für erfindungsgemäße Gradientenspulen. Aus diesem Grund beschränkt sich die Darstellung der in Fig. 2 dargestellten erfindungsgemäßen Anordnung auf die Berechnung der *stream function* und die Darstellung derselben mit Hilfe von Konturlinien. Im Übrigen wird bis auf wenige Ausnahmen auf die numerische Berechnung optimaler Anordnungen verzichtet und dem Fachmann wird überlassen, die Optimierung selbst durchzuführen, wozu der Stand der Technik und die Beschreibung dieser Erfindung genügend Informationen bereithalten. Allerdings wird im Folgenden auf Besonderheiten erfindungsgemäßer Anordnungen hingewiesen, die der Fachmann bei der Konstruktion erfindungsgemäßer Gradientenspulen und Gradientensysteme berücksichtigen sollte.

Wie schon angesprochen kann das in Fig. 1 gezeigte Design unmittelbar Anwendung finden in einem aus dem Stand der Technik bekannten Gradientensystem, welches aus konzentrischen Schalen besteht (s. auch Fig. 3a). Problematisch ist dabei jedoch, dass die zwei anderen Gradientenspulen nicht identisch konstruiert werden können, sondern einen unterschiedlichen Radius aufweisen müssen. So wurden auch Designs analog zu Fig. 1 berechnet, allerdings mit einem Radius von 34cm bzw. 36cm anstatt 35cm, die eine Effizienz von $89 \frac{\mu T}{m \cdot A}$ bzw. $82 \frac{\mu T}{m \cdot A}$ aufwiesen. Trotz der Ähnlichkeit der resultierenden Anordnungen ergeben sich aufgrund des schalenförmigen Aufbaus mit unterschiedlichen Radien somit noch Effizienzunterschiede in Höhe von fast 10%, was beispielsweise Probleme in Bezug auf die Wärmentwicklung während des Betriebes nach sich führen kann. Diese Unterschiede der Spuleneigenschaften und die damit zusammenhängenden Probleme werden behoben, wenn ein Gradientensystem in der Art konstruiert wird, wie in dieser Schrift beschrieben, wenn beispielsweise ein geschlossenes, stufenförmiges Design wie in Fig. 3b dargestellt verwendet wird mit drei identisch ausgestalteten Gradientenspulen, die aus geschlossenen stromführenden Leitern bestehen, die auf einer stufenförmigen Fläche angeordnet sind.

Beispielhaft soll hier ein Vorteil beschrieben werden, der dadurch entsteht, dass nach dieser Erfindung vollständig identische Spulen verwendet werden. Im letzten Abschnitt wurde gezeigt, dass es Effizienzunterschiede von bis zu 10% gibt, wenn Gradientenspulen eines Gradientensystems auf Schichten unterschiedlicher Radien konstruiert werden, der in [P1] = EP 1 122 552 B1 beschriebenen Erfindung folgend, so dass das Gradientensystem keine 120°-Symmetrie aufweist (d.h. so dass die Anordnung hinsichtlich der drei Gradientenspulen keine 120°-Symmetrie aufweist), obwohl die Kodierrichtungen selbst diese Symmetrieeigenschaft besitzen. Ähnliches gilt auch für die zwei Transversalspulen bei einem typischerweise verwendeten x-y-z-Gradientensystem.

Dies führt dazu, dass je nach Kodierrichtung das Gradientensystem nach dem Stand der Technik unterschiedlich effizient ist, so dass auch die Verlustleistung von der Kodierrichtung abhängt, was den ungünstigen Effekt hat, dass auch die Wärmentwicklung von der Kodierrichtung abhängt.

Dies führt seinerseits zu Beschränkungen bei Aufnahmen mit einem MR-Tomographen. Es soll nun detailliert gezeigt werden, dass die Verlustleistung unabhängig ist von der Kodierrichtung, wenn ein erfindungsgemäßes Gradientensystem gewählt wird.

Dies wird anhand eines Magic-Angle-Gradientensystems gezeigt, allerdings gelten die gleichen Überlegungen für erfindungsgemäß ausgeformte Transversalspulen, wobei hier zudem beachtet werden muss, dass eine konstante Verlustleistung nur für solche Kodierrichtungen besteht, die die gleiche z-Komponente aufweisen, d.h. die Überlegungen gelten nur für Variationen der Kodierrichtung entlang eines Vektors in der Transversalebene.

Des Weiteren wird davon ausgegangen, dass die drei von den Gradientenspulen erzeugten Gradientenrichtungen $\mathbf{e}_1'$, $\mathbf{e}_2'$ und $\mathbf{e}_3'$ orthogonal aufeinander stehen. Aufgrund der Tatsache, dass alle drei erfindungsgemäßen Gradientenspulen die gleiche Bauweise aufweisen, haben sie die gleiche Effizienz $g$ und erzeugen somit bei gleicher Stromstärke $I$ dieselbe Gradientenstärke $G = gI$. Die vektorielle Größe der Gradientenstärken ist somit gegeben durch

$$\mathbf{G}_{1,2,3} = gI\mathbf{e}_{1,2,3}'.$$

Nun können im Allgemeinen die Spulen mit unterschiedlichen Stromstärken $I_{1,2,3}$ betrieben werden. Aufgrund des Superpositionsprinzips ergibt sich dann für das resultierende Gradientenfeld $\mathbf{G}_r = \sum_{i=1}^{3} \mathbf{G}_i = g \sum_{i=1}^{3} I_i \mathbf{e}_i'$, wobei es aufgrund der linearen Unabhängigkeit von $\mathbf{e}_1'$, $\mathbf{e}_2'$ und $\mathbf{e}_3'$ genau eine Kombination von Stromstärken $I_{1,2,3}$ gibt, die dieses Gradientenfeld erzeugt. Soll nun unabhängig von der Kodierrichtung er ein Gradientenfeld derselben Stärke $G_0$ erzeugt werden, so gilt: $const = G_0^2 = \|\mathbf{G}_r\|^2 = \left\| g \sum_{i=1}^{3} I_i \mathbf{e}_i' \right\|^2 = g^2 \sum_{i=1}^{3} I_i^2$ und somit auch $\sum_{i=1}^{3} I_i^2 = const.$ Dies ist eine unmittelbare Folgerung aus der Orthogonalität von $\mathbf{e}_1'$, $\mathbf{e}_2'$ und $\mathbf{e}_3'$. Die Summe der Stromquadrate ist somit für alle Kodierrichtungen gleich.

Nun ist aber die Verlustleistung $P$ gegeben durch die Summe der in jeder einzelnen Spule entstehenden Verlustleistung $P_{1,2,3}$, d.h. $P = \sum_{i=1}^{3} P_i$, wobei mit dem für alle drei Spulen gleichen Widerstand R für die Verlustleistung der einzelnen Spulen gilt: $P_{1,2,3} = RI_{1,2,3}^2$. Die gesamte Verlustleistung ist somit gegeben durch

$$P = \sum_{i=1}^{3} P_i = R \cdot \sum_{i=1}^{3} I_i^2 = const.$$ Dieser Term ist wie oben gezeigt unabhängig von der Kodierrichtung. Damit ist bewiesen, dass die Behauptung wahr ist, bei identischer Bauweise der drei Spulen sei die Verlustleistung unabhängig von der Kodierrichtung, ein Vorteil, der nach dem Stand der Technik nicht besteht.

Wird nun ein Gradientensystem mit geschlossenen stufenförmigen Flächen von stromführenden Leitern im Sinne dieser Erfindung wie in Fig. 3b dargestellt verwendet und nicht ein Gradientensystem mit zylinderförmigen Leiterschalen, so wird sich eine optimale Verteilung von Stromleitern in diesem Fall nicht sehr stark von der in Fig. 1b gezeigten Anordnung unterscheiden, da die kurzen radialen Verbindungsleiter zwischen den Schichten keinen sehr großen Einfluss haben, da sich der Radius nur um wenige Millimeter bis wenige Zentimeter ändert.

So wäre es beispielsweise möglich, die in Fig. 1b gezeigte Anordnung von Stromleitern unmittelbar zu verwenden und durch passende Verbiegung in die vorgesehene Geometrie zu formen. Ein Gradientensystem mit verbesserten Eigenschaften ließe sich allerdings entwickeln, wenn die veränderte Geometrie unmittelbar in das für die Optimierung verwendete Berechnungsverfahren integriert würde. Dies wird im nächsten Abschnitt im Detail für ein spiralförmiges offenes Design gezeigt, allerdings ist dem Fachmann bewusst, wie er die bekannten Optimierungsverfahren auch auf andere Fälle anwenden kann, wie auch auf den soeben beschriebenen Fall eines geschlossenen Designs mit stufenförmigem Aufbau.

<u>Fig. 2</u> zeigt ein erfindungsgemäßes spiralförmiges Design **020**, bei dem erstens die in Fig. 1 gezeigte zylinderförmige Fläche von stromführenden Leitern nicht geschlossen ist, sondern offen, und zweitens die offenen Seiten nicht bündig aneinander anschließen, sondern radial um 3cm versetzt sind. Der innere Radius beträgt $r_i$ = 34cm, der äußere $r_\alpha$ = 37cm. Man beachte, dass im Rahmen dieser Erfindung im Grunde die gleiche Eigenschaft gemeint ist, wenn die Begriffe "geschlossen", "halb-geschlossen" oder "offen" auf das gesamte

Gradientensystem bezogen werden, auf die Gradientenspulen, die Flächen von stromführenden Leitern beziehungsweise auf die Anordnung der stromführenden Leiter. Das gleiche gilt, wenn der Begriff "Design" verwendet wird oder "die Anordnung" oder dergleichen. Ähnliches gilt für die Begriffe "spiralförmig und/oder stufenförmig", die eine einheitliche Eigenschaft beschreiben, unabhängig davon, ob beispielsweise davon gesprochen wird, dass die Gradientenspulen (oder Elemente dieser Spulen) selbst diese Eigenschaft haben oder die Flächen (bzw. Oberflächen), auf denen die stromführenden Leiter der Gradientenspulen angeordnet sind.

Das offene Design bedingt, dass die stromführenden Leiter **021** der Spule in azimutaler Richtung offen ausgeformt sind. Das spiralförmige Design kann auch als "im Wesentlichen zylinderförmig" oder schlicht als "zylinderförmig" bezeichnet werden, da die Abweichung von einer reinen zylinderförmigen Geometrie gering ist und immer noch gut einer zylinderförmigen Bohröffnung angepasst ist. Ein Gradientensystem, welches aus solchen spiralförmigen (und/oder stufenförmigen) Gradientenspulen besteht, soll somit auch selbst noch als "zylinderförmig" bezeichnet werden. Soweit durch den Kontext keine Verwechslungsgefahr besteht, gilt diese sprachliche Vereinfachung auch für die Gradientenspulen selbst, bzw. für die Flächen, auf denen die stromführenden Leiter angeordnet sind.

Fig. 2a zeigt optimierte Konturlinien der für die in Fig. 2b in Seitenansicht dargestellte spiralförmige Anordnung. Bezüglich des offenen Designs ist Folgendes zu beachten: Während in Fig. 1 die Seitenbegrenzung **011** gestrichelt gezeichnet ist, ist sie in Fig. 2a durchgängig gezeichnet **(022),** womit deutlich gemacht werden soll, dass die Seiten nicht miteinander verbunden sind. Je nachdem, bei welchem Winkel die Fläche aufgetrennt wird, ergibt sich durch die verwendete numerische Methode eine unsymmetrische Anordnung oder eine solche, die eine 180°-Symmetrie in der $\theta$ - z-Ebene aufweist. In dem hier gezeigten Beispiel wurde für die Kodierrichtung e ein Winkel von 90° gewählt, um die in Fig.2a gezeigte nahezu symmetrische Anordnung zu erzeugen.

Bei dem Optimierungsproblem wurden anders als für die Berechnung des geschlossenen Designs die Dreiecke des Meshes des rechten Randes nicht mit denjenigen des linken Randes verbunden. Die Seitenlinien **022** bildeten vielmehr einen Teil des Randes in der Berechnung eines optimalen Designs.

Bezüglich der Spiralform wurde bei der Berechnung Folgendes beachtet: Anstatt der im zweiten Abschnitt der detaillierten Beschreibung zu Fig. 1 gewählten Parametrisierung wurde folgende Parametrisierung der Oberfläche verwendet: $S = \{\mathbf{x}(\theta, z) \in \mathbb{R}^3 | \theta = [0°, 360°]$, z = [-60 cm, 60 cm]}, wobei $x(\theta, z) = r(\theta) \cos \theta$, $y(\theta, z) = r(\theta) \sin \theta$ und $z(\theta, z)$ = z, mit $r(\theta) = r_i + (r_a - r_i)\frac{\theta}{360°}$.

Neben diesen Abweichungen wurden dieselben Parameter verwendet wie in dem in Fig. 1 a gezeigten Design.

Das in Fig. 2 gezeigte Design hat eine Gradientenstärke von $73 \frac{\mu\text{T}}{\text{m}\cdot\text{A}}$ bei einem Widerstand von 27 $m\Omega$. Bezüglich der Gradientenstärke ergaben sich insofern im Vergleich zu einem geschlossenen Design lediglich Effizienzverluste von etwa 15%.

<u>Fig. 3</u> zeigt in Seitenansicht drei verschiedene Anordnungen der drei Gradientenspulen (mit Kompensationsspulen), die unterschiedliche Gradientensysteme bilden.

Fig. 3a zeigt einen aus dem Stand der Technik bekannten schalenförmigen Aufbau, bei dem die Leiter der drei Gradientenspulen **030** einen leicht unterschiedlichen, für sich aber konstanten Radius haben, somit geschlossene übereinanderliegende Zylinder bilden, so dass sich die stromführenden Leiter in geometrischer Hinsicht auf gekrümmten zylinderförmigen Oberflächen **030a** befinden. Fig. 3a zeigt eine Situation, in der die drei Gradientenspulen durch drei Kompensationsspulen **031** für eine aktive Abschirmung der magnetischen Felder nach außen ergänzt sind. Dabei sind die drei Kompensationsspulen ebenfalls schalenförmig angeordnet, wobei die Reihenfolge der Kompensationsspulen im Verhältnis zu den Gradientenspulen dem Grunde nach beliebig gewählt werden kann, typischerweise aber die gleiche Reihenfolgen haben, d.h. mit ansteigendem Radius Gradientenspule 1, Gradientenspule 2, Gradientenspule 3, Kompensationsspule 1, Kompensationsspule 2, Kompensationsspule 3.

Fig. 3b zeigt ebenfalls ein geschlossenes Design eines Gradientensystems mit drei stufenförmigen Gradientenspulen **032** und drei Kompensationsspulen **033,** wobei aber die drei Gradienten- und Kompensationsspulen sowie das (im Wesentlichen) zylinderförmig geformte Gradientensystem erfindungsgemäß konstruiert sind, da die Spulen eine identische Geometrie aufweisen, lediglich rotiert um 120°. Dies bedeutet: Wenn das Gradientensystem somit um eine z-Achse des Gradientensystems (die Zylinderachse) um einen Winkel $\alpha2 = 120°$ rotiert wird, unabhängig davon, ob in die eine oder die andere Richtung rotiert wird, werden die drei identischen Spulen (in geometrischer Hinsicht) ineinander überführt. Das Gradientensystem weist somit (hinsichtlich der identischen Spulen) eine 120°-Symmetrie auf. Diese Symmetrie bei Identität der drei Spulen wird dadurch erreicht, dass die Stromleiter einer Spule nicht insgesamt einen konstanten Radius aufweisen, sondern zweimal den Radius ändern. So befindet sich jeweils die ersten 120° oder wie dargestellt nahezu 120° auf der ersten Schale, die zweiten 120° auf der zweiten Schale und die dritten 120° auf der dritten Schale. An den Übergangsstellen gibt es kurze Leiterbrücken **034a, 034b,** die eine radiale Stromkomponente aufweisen. Denkbar ist ein offenes oder halbgeschlossenes Design, dargestellt ist aber ein geschlossenes Design, bei dem die dritte Schale vollständig mit der ersten Schale über kurze Leiterbrücken **035** in Verbindung steht.

Fig. 3c zeigt ein spiralförmiges offenes Design mit drei Gradientenspulen **036** und drei Kompensationsspulen **037.** Die in Fig. 3c dargestellte Anordnung enthält jeweils drei identische Gradientenspulen **038a, 038b** und **038c,** jeweils um 120° rotiert. Das gleiche gilt für die drei Kompensationsspulen. Die in Fig. 3c dargestellte Ausführungsform besteht aus Spulen, die eine größere Ausdehnung als 360° in azimutaler Richtung haben und offen sind, bei denen die beiden Enden **039a** und **039b** der Spulengeometrie also einen Winkel von mehr als 360° umschließen. Eine andere nicht dargestellte Ausführungsform umschließt beispielsweise nur einen Gesamtwinkel von 360°; für diese Ausführungsform könnten beispielsweise Gradientenspulen verwendet werden mit einem Design wie in Fig. 2 dargestellt.

Weitere nicht dargestellte Ausführungsformen sind halb-geschlossen oder vollständig geschlossen. Dabei ist ähnlich wie bei dem in Fig. 3b dargestellten Design auf eine sinnvolle Verdrahtung zu achten, s. auch die Diskussion zu Fig. 6. Neben vielen anderen möglichen Ausführungsformen sei auch eine solche explizit genannt, bei der der Abstand der stromführenden Leiter der Kompensationsspulen zur Mitte der Geometrie nicht wie in Fig. 3b und Fig. 3c gegen den Uhrzeigersinn sukzessive zunimmt, sondern im Uhrzeigersinn, d.h. entgegen der Richtung der radialen Zunahme der Leiter der Hauptgradientenspulen.

Das stufenförmige Design hat unter anderem den Vorteil gegenüber dem spiralförmigen Design, dass es sich in sehr einfache Art an eine zylinderförmige Geometrie anpasst, was Vorteile bei der Produktion mit sich bringen kann; so können beispielsweise einfach geformte zylinderförmige Montageelemente ohne besondere Ausgestaltung verwendet werden. Allerdings ergibt sich ein erhöhter Montageaufwand an den Stellen, an denen die Leiter von der inneren auf die äußere Schicht wechseln.

Dieses Problem besteht nicht bei Verwendung spiralförmiger Designs, da sich hier der Abstand zum Zentrum kontinuierlich ändert, so dass die Spulen einfach aufgewickelt werden können. Allerdings könnte es sinnvoll sein, die zylinderförmigen Montageelemente mit Keilen oder ähnlichen Besonderheiten auszustatten, um eine korrekte Biegung der Spulenelemente bei der Konstruktion des Gradientensystems sicherzustellen.

Auch erfindungsgemäß sind solche Ausführungsformen, die einer spiralförmigen oder stufenförmigen Konstruktion ähnlich sind. So ist es beispielsweise möglich, dass die Leiterbrücken **034a, 034b** oder **035** unabhängig voneinander steiler (bis hin zu vertikal) verlaufen oder flacher; in diesem Sinn stellt das spiralförmige Design einen Extremfall besonders flacher Leiterbrücken dar. Auch andere als gerade Leiterbrücken sind denkbar, beispielsweise solche mit nicht-abrupter Richtungsänderung. Auch eine Kombination von spiralförmiger und stufenförmiger Konstruktion könnte im Einzelfall von Nutzen sein.

Die Erfindung bezieht sich auf solche Variationen und weitere ähnliche Ausführungsformen. Dabei ist zu beachten, dass sich die identische 120°-Symmetrie nur auf die stromführenden Leiter des Gradientensystems bezieht, deren primäres Ziel darin besteht, ein magnetisches Feld innerhalb des Gradientensystems zu erzeugen (Entsprechendes gilt für alle in dieser Schrift beschriebenen Gradientensysteme, auch für Gradientensysteme mit zwei identischen Transversalspulen (s. z.B. Fig. 7b oder Fig. 7c) oder für die erfindungsgemäßen Gradientensysteme mit im Wesentlichen planarer oder biplanarer Geometrie). Hilfskomponenten wie Gradientenverstärker finden keine Berücksichtigung, wie auch Strom zu- und abführende Leiter, sofern sie nicht eine besondere Geometrie aufweisen, die der Manipulation des erzeugten Gradientenfeldes dienen und somit als Teil des Gradientenspulendesigns selbst anzusehen sind. So soll im Sinne dieser Erfindung die Symmetrieeigenschaft als erhalten gelten, wenn beispielsweise die Strom zu- und abführenden Leiter aus Praktikabilitätsgründen an einem Ort gebündelt werden, um die Verbindung mit den Gradientenverstärkern zu vereinfachen, ohne jedoch einen signifikanten Beitrag zum Gradientenfeld innerhalb des Untersuchungsbereiches zu liefern.

Die in Fig. 3c dargestellten Gradientenspulen nehmen anders als das in Fig. 2 gezeigte Design eine Ausdehnung in azimutaler Richtung von mehr als 360° ein. Ein solches Design numerisch zu berechnen stellt keine Schwierigkeiten dar, es ist lediglich darauf zu achten, dass bei der Parametrisierung der Oberfläche ein Winkel $\Theta_{max} > 360°$ gewählt

wird, *d.h.* $S = \{\mathbf{x}(\theta, z) \in \mathbb{R}^3 \mid \theta = [0°, \Theta_{max}],\ z = [-60\ \text{cm}, 60\ \text{cm}]\}$. Die Wahl eines Designs mit einer azimutalen Ausdehnung von mehr als einer vollständigen Umrundung kann Vorteile bieten, insbesondere, wenn die Spulen kräftemäßig ausbalanciert sein sollen. Dies soll im Folgenden genauer erläutert werden.

Allerdings ist zunächst Vorsicht geboten, wie sich aus Fig. 4 ergibt: Fig. 4 zeigt ein offenes Design mit $\Theta_{max}$ > 360°, welches aus dem geschlossenen, in Fig. 1 gezeigten, kräftemäßig ausbalancierten Design entwickelt wurde. Fig. 4a wiederholt in dem schwarzen Kasten das Design aus Fig. 1 b. Allerdings werden die Stromleiter **040** an den zwei vertikalen schwarzen Linien **041a** und **041b** durchtrennt. Die offenen Enden werden dann über die grau gezeichneten Stromleiter **042** und **043** miteinander verbunden. Da sich keine großen Abweichungen ergeben, kann in erster Näherung für die folgenden Überlegungen die Tatsache ignoriert werden, dass ein solches Design nur schwer auf einer reinen Zylinderoberfläche realisiert werden kann, und besser spiralförmig, stufenförmig oder ähnlich angeordnet werden sollte, s. beispielsweise die Darstellung in Fig. 3c. Aus Fig. 4a wird ersichtlich, dass die zusätzlichen Stromleiter **042** und **043** exakt einen Abstand von 360° oder genau von einer Rotation haben. Der Effekt dieser zusätzlichen Ströme ist also derselbe wie in Fig. 4b eingezeichnet, bei dem die Stromleiter **043** um eine Rotation versetzt dargestellt sind. Aus Fig. 4b geht nun hervor, dass die zusätzlichen verbindenden Stromleiter Stromschleifen bilden ("additional currents" = zusätzliche Ströme). Diese Stromschleifen liegen (nahezu) auf einer Zylinderoberfläche und haben somit ein magnetisches Moment in radialer Richtung. Dieses magnetische Moment tritt mit dem Hauptmagnetfeld in Wechselwirkung. Da das Hauptmagnetfeld entlang der z-Achse ausgerichtet ist, ergibt sich ein resultierendes Drehmoment in azimutaler Richtung. Das in Fig. 4a dargestellte Design ist daher nicht kräftemäßig ausbalanciert.

Es bestehen nun mehrere Möglichkeiten, mit diesem Problem umzugehen. Eine Möglichkeit besteht darin, ein Design zu akzeptieren, welches nicht 100% kräftemäßig ausbalanciert ist.

Ein sinnvolles Design könnte beispielsweise in der Art entwickelt werden, dass der Term $\lambda\mathbf{M}$ in dem Zielfunktional $\Phi$ durch den Term $\omega\mathbf{M}$ ersetzt wird, wobei $\omega$ kein Vektor von drei Lagrange-Multiplikatoren ist, sondern ein Vektor mit drei zusätzlichen Gewichten, durch deren Variation der Grad dessen angepasst werden kann, wie sehr das resultierende Design kräftemäßig ausbalanciert ist.

Eine andere Möglichkeit besteht darin, wie in Fig. 4c dargestellt, die nichtkompensierten Ströme durch Gegenströme zu kompensieren ("compensating currents" = kompensierende Ströme). Dies kann durch Anlegen passender Gegenspannungen jeweils am Anfang und am Ende der in Fig. 4a grau gezeichneten Stromleiter **042** und **043** geschehen oder aber durch eine separate Kompensationsspule unter Verwendung eines eigenen Gradientenverstärkers oder auch desselben, der für die Hauptgradientenspule verwendet wird.

Bei der in Fig. 4 gezeigten Anordnung von Stromleitern bietet sich eine Approximation der in Fig. 4c dargestellten schleifenförmigen Stromleiter **045** durch einen einzigen wirbeiförmigen Stromleiter an. Die Kompensationsspule könnte auch dadurch realisiert werden, dass die Leiter **044a** und **044b,** die die stromführenden Leiter der Gradientenspule mit der Stromquelle verbinden, so angeordnet sind, dass sie das nicht-kompensierte Drehmoment ausgleichen.

Auch besteht die Möglichkeit, eines halb-offenen Designs, bei dem ein Teil der Stromleiter des einen Endes mit dem anderen Ende verbunden werden, ein Teil aber ähnlich wie die grau eingefärbten Leiter am Spulenende zurückgeführt werden. Dies erhöht die Effizienz, reduziert das Problem des Kräftegleichgewichts (i.e. des kräftemäßigen Ausbalanciertseins) und vereinfacht die Verdrahtung auch bei erfindungsgemäßen, zum Beispiel bei spiralförmigen Designs.

Des Weiteren kann es sehr nützlich sein, von vorneherein ein kräftemäßig ausbalanciertes Grunddesign zu entwickeln. Dass dies ohne größere Schwierigkeiten möglich ist, zeigt **Fig. 5.** Hier sind drei Situationen dargestellt, die aufbauend auf dem geschlossenen kräftemäßig ausbalancierten Design von Fig. 1, offene Designs zeigen. Dabei ist lediglich eine einzelne Leiterschleife dargestellt (ohne Belang für die Überlegungen ist, dass die Leiterschleife in sich geschlossen dargestellt ist, ähnlich einer Konturlinie der *stream function;* für ein praktisches Design ist der Leiter leicht seitlich versetzt nach einer Umrundung, wie in Fig. 4 gezeigt). Für das Problem des Kräftegleichgewichts genügt es, eine einzige Leiterschleife zu betrachten, die Überlegungen lassen sich problemlos auf mehrere Umrundungen verallgemeinern. Fig. 5a zeigt eine Situation mit positivem Drehmoment, Fig. 5b mit negativem Drehmoment und Fig. 5c mit keinem Netto-Drehmoment.

Betrachte zunächst Fig. 5a. Diese Situation entspricht unmittelbar der in Fig. 4 dargestellten Situation. Die dargestellte Leiterschleife besteht aus dem kräftemäßig ausbalancierten Stromleitern **050** sowie den Verbindungsleitern **051a, 051b.** Hier wurde ein Winkel $\Theta_{max}$ gewählt, der deutlich größer ist als 360°; dieser Winkel beschreibt auch in diesem Zusammenhang die Ausdehnung der Gradientenspule in azimutaler Richtung. Wie anhand von Fig. 4 schon gezeigt, ergibt sich somit ein positives (es ist Definitionssache, ob ein Drehmoment als positiv oder als negativ bezeichnet wird, wenn der Strom im Uhrzeigersinn fließt; hier sei bei Strom im Uhrzeigersinn das Drehmoment als positiv definiert) Netto-Drehmoment, welches durch das Hauptmagnetfeld auf die Gradientenspule einwirkt. Ein entgegengesetzt gerichtetes (negatives) Drehmoment entsteht in der in Fig. 5b dargestellten Situation. Hier wurde ein Winkel von $\Theta_{max}$ = 360° gewählt.

Wie Fig. 2 zeigt, ist es zwar auch für diese Situation möglich, ein kräftemäßig ausbalanciertes Design zu entwerfen, allerdings ergibt eine einfache Verbindung des oberen mit dem unteren Leiter über die Leiterabschnitte **052a, 052b** ein insgesamt negatives Drehmoment. Zu berücksichtigen ist nämlich, dass die für das geschlossene kräftemäßig ausbalancierte Design genutzten Leiterstücke **053a - 053d** nicht mehr verwendet werden und somit de facto ein entgegengerichteter Strom in diesen Leiterstücken bei der Berechnung der Nettostromänderung berücksichtigt werden muss. Es ergibt sich somit eine Nettoleiterschleife in der Form **054** mit negativem Drehmoment.

Während also ein zu kleiner Winkel ($\Theta_{max}$ = 360°) in diesem Fall ein negatives Drehmoment aufweist, existiert ein positives Drehmoment, wenn der Winkel zu groß gewählt wird. Es muss somit einen optimalen Winkel geben, bei dem das resultierende Drehmoment exakt verschwindet.

Diese Situation ist in Fig. 5c dargestellt. Man sieht, dass auch in dieser Situation $\Theta_{max}$ größer ist als 360°. Die Nettostromschleife **057** kann in diesem Fall offensichtlich in drei kleinere Schleifen zerlegt werden, von denen zwei ein negatives Drehmoment erzeugen und eine ein positives Drehmoment. An dem Punkt, an dem die Addition der drei Drehmomente null ergibt, ergibt sich ein Design, welches kräftemäßig ausbalanciert ist.

Dem Fachmann ist bekannt, wie Drehmomente **M** berechnet werden können. So weiß er, dass es sich aus dem Vektorprodukt von magnetischem Moment **m** und Magnetfeld **B**, d.h. **M** = **m** $\times$ **B**, ergibt, wobei **m** = $I/2 \oint_\Gamma$ **x** $\times$ d**x** ; in dieser Definition wird mit $I$ die Stromstärke in einem Leiter entlang der Kurve Γ bezeichnet und **x** bezeichnet den Ortsvektor.

Beispielsweise ist das resultierende Drehmoment für eine ebene Leiterschleife proportional zu der Fläche, die von der Leiterschleife umschlossen wird, wobei die Fläche positiv zählt bei Stromfluss in positiver Richtung und negativ bei Stromfluss in negativer Richtung. In erster Näherung ist somit ein kräftemäßig ausgeglichenes Design dadurch ausgezeichnet, dass sich bei der sich aus drei Teilen zusammensetzenden Netto-Stromschleife **057** die Summe der oberen und der unteren Fläche gerade der mittleren Fläche entspricht.

Dies stimmt für zylinderförmige Designs nur approximativ, da es sich nicht um ebene Leiterschleifen handelt, allerdings weiß der Fachmann, wie er exakte Berechnungen durchführen müsste; so könnte er beispielsweise die oben angegebene Formel für die Berechnung des Drehmomentes verwenden.

Zusammenfassend kann festgehalten werden, dass es durchaus technische Vorteile haben kann, eine Anordnung zu wählen mit einer Ausdehnung entlang der azimutalen Richtung von mehr als genau einer Umrundung. Dabei können wenige Grad ausreichend sein, allerdings bieten sich umso mehr Freiheitsgrade und somit Optimierungsmöglichkeiten, je größer die Ausdehnung der Gradientenspule in azimutaler Richtung ist, da in diesem Fall eine größere Fläche für das Platzieren von Stromleitern zur Verfügung steht.

Realisierbar wird ein solches Design durch einen spiralförmigen, aber auch durch einen stufenförmigen oder ähnlichen Aufbau des Gradientensystems. Neben vollständig offenen Designs können zur Effizienzsteigerung auch teilweise offene (i.e. halb-geschlossene) Designs gewählt werden, bei denen nur ein Teil der stromführenden Leiter wie in Fig. 4 oder Fig. 5 gezeigt zurückgeführt wird, der andere Teil aber geschlossene Stromleiter bildet, wie in Fig. 1 gezeigt.

<u>Fig. 6</u> zeigt ein Problem auf, welches auftreten kann, wenn ein geschlossenes erfindungsgemäßes Design gewählt wird, wie beispielsweise das in Fig. 3b gezeigte stufenförmige Design. Wird ein solches geschlossenes Design konstruiert, ist darauf zu achten, dass sich Leiterbahnen kreuzen können.

Dies ist in Fig. 6a veranschaulicht, eine Seitenansicht eines Ausschnittes eines geschlossenen spiralförmigen Designs, für das ähnliche Probleme in dieser Hinsicht bestehen wie für stufenförmige Designs. Die Pfeile geben die radiale Richtung nach innen ("inwards") und nach außen ("outwards") an. Nach einer Umrundung erreicht eine Spule ("coil") seinen maximalen Radius außen bei **060**. Um die Stromleiter mit dem anderen Ende der Spule, innen bei **063** zu verbinden, müssen die zwei beiden anderen Spulenschichten gekreuzt werden bei **061** und **062.**

Dies ist technisch allerdings durchaus realisierbar, wie Fig. 6b zeigt, da entlang der z-Richtung genug Raum vorhanden ist, so dass die verbindenden Stromleiter an jeweils unterschiedlichen Stellen mit Beginn bei **063a - 063e** und Ende **060a - 060e** nach innen geführt werden. Allerdings können leichte Modifikationen an dem optimierten Design notwendig werden, wie Fig. 6b illustriert. Fig. 6b soll andeuten, dass vertikal verlaufende, den äußeren mit dem inneren Teil der Spule verbindende Stromleiter zur Folge haben, dass die zwei anderen Gradientenspulen an einer bestimmten Position passiert werden müssen.

Da es sich um eine 120°-Symmetrie handelt, genügt es, in Fig. 6b, die eine Aufsicht der Spulengeometrie in θ - z-Koordinaten zeigt, ein einziges Spulendesign darzustellen; die Punkte, an denen die zwei anderen Schichten gequert werden müssen, sind um 120° bzw. 240° (=-120°) versetzt und sind mit **062a - 062e** bzw. **061a - 061e** bezeichnet.

Es fällt auf, dass es Bereiche gibt, in denen die Dichte der Stromleiter gering ist. In diesen Bereichen können die vertikal verlaufenden Stromleiter nahezu ungehindert passieren (evtl. ist geringfügiges Verschieben bzw. Verbiegen von Leitern notwendig). Allerdings gibt es auch Bereiche höherer Stromleiterdichte, die nicht ohne Weiteres gekreuzt werden können. An diesen Stellen ist es notwendig, technische Vorkehrungen zu treffen.

Dies kann entweder dadurch erreicht werden, dass an Orten hoher Dichte von Stromleitern (a) die Anzahl der vertikal verlaufenden Stromleiter reduziert wird, oder aber indem (b) die Dichte der horizontal verlaufenden Stromleiter (die von den vertikal verlaufenden, verbindenden Stromleitern gekreuzt werden) reduziert wird.

Zu (a): Es bestehen mehrere Möglichkeiten, die Anzahl der vertikal verlaufenden Stromleiter zu reduzieren.

(i) Die in Fig. 6 dargestellte Situation weicht mit einem Verkippungswinkel von 45° gegenüber der Transversalebene vom Optimum ab, welches bei 35,26° liegt. Wird der Verkippungswinkel reduziert, erhöht sich der Transversalanteil der Spule und der Longitudinalanteil wird kleiner. Da aber nur der Longitudinalanteil Wicklungen um den Spulenkörper mit sich bringt, reduziert sich die Anzahl der Wicklungen, wenn ein kleinerer Verkippungswinkel gewählt wird, so dass weniger vertikal verlaufende Stromleiter benötigt werden.

(ii) Eine weitere Möglichkeit, die Anzahl der vertikal verlaufenden Stromleiter in dichten Bereichen zu reduzieren besteht darin, die Position zu verändern, an der die Stromleiter von außen nach innen geführt werden. Dies kann durch eine Verschiebung entlang der z-Richtung oder aber der $\theta$-Richtung erfolgen. Entlang der z-Richtung besteht sogar die Möglichkeit, einen einzigen, mehrere oder sogar alle Stromleiter über den Rand von $z = \pm 60 cm$ hinauszuführen, um sie dann neben der Spule von außen nach innen zu führen; wird dies getan, können die Stromleiter dann wieder entlang der entgegengesetzten z-Richtung an die richtige Position zurückgeführt werden. Diese Herangehensweise hat den Vorteil, dass keine störenden Stromleiter der anderen beiden Gradientenspulen passiert werden müssen. Außerdem hat ein Leiter, der entlang der z-Achse verläuft, keinen Beitrag zum für die Kodierung relevanten $B_z$-Feld, so dass diese Leiterstücke auf die Kodierung selbst so gut wie keinen Einfluss haben.
Neben der Möglichkeit, die Stromleiter jenseits des Randes der Spule vertikal hinabzuführen, bietet vor allem auch die Mitte bei $z = 0$ viel Raum für vertikal querende Stromleiter. Wie schon angesprochen kann es aber auch nützlich sein, Stromleiter nicht nur an anderen Positionen in z-Richtung vertikal hinabzuführen, sondern auch an anderen Stellen in $\theta$-Richtung. Dies ist unproblematisch, weil es die erfindungsgemäßen Spulendesigns in der Regel zulassen, dass die Gradientenspule einen Gesamtwinkel von $\theta_{max} > 360°$ umschließt. Bei geschlossenen Designs ist es dem Grunde nach gleichgültig, bei welchem $\theta$ -Winkel das eine mit dem anderen Ende verbunden wird. Es kann daher einfach eine Stelle gewählt werden, bei der die Dichte der zu passierenden Stromleiter gering genug ist, um passiert zu werden.

(iii) Eine dritte Möglichkeit, die Anzahl der vertikal verlaufenden Stromleiter zu reduzieren, besteht darin, keine vollständig geschlossenen Anordnungen von Stromleitern zu wählen, sondern halb-geschlossene Anordnungen, bei denen ein Teil der stromführenden Leiter mit den rücklaufenden Leitern auf der anderen Seite der z-Achse verbunden werden, bis hin zu vollständig offenen Anordnungen, bei denen überhaupt kein vertikal verlaufender Leiter benötigt wird, da in diesem Fall alle Leiter mit den rücklaufenden Leitern verbunden werden, wie in Fig. 4 dargestellt.

Neben diesen Methoden, die Anzahl der vertikal verlaufenden Leiter in Bereichen hoher Leiterdichte der zu passierenden Gradientenspulen zu reduzieren, sind weitere Varianten der eben beschriebenen denkbar. Allerdings kann auch Methode (b) (alternativ oder auch ergänzend) herangezogen werden, wonach die Dichte der horizontal verlaufenden Stromleiter an Stellen reduziert wird, an denen vertikal verlaufende Stromleiter (die den äußeren mit dem inneren Teil einer Spule verbinden) kreuzen. Dies kann dadurch erreicht werden, dass von der optimalen Geometrie abgewichen wird, indem Leiter in der $\theta$ - z-Ebene in geeigneter Weise verschoben werden.

Es ist auch in Grenzen möglich, den Leiterquerschnitt zu reduzieren, jedenfalls in der z- oder der $\theta$-Richtung. Allerdings ist dem Grenzen gesetzt, da hierdurch lokal höhere Widerstände eingebaut werden, an denen möglicherweise eine ausreichende Kühlung sichergestellt werden müsste. Eine Kühlung ließe sich allerdings entlang der vertikal verlaufenden Leiter zusätzlich einbauen, so dass eine Reduzierung des Leiterquerschnittes denkbar wäre. Aufgrund der anderen hier vorgestellten Methoden, wird dies aber in der Regel nicht notwendig sein, um ein erfindungsgemäßes geschlossenes Gradientensystem zu realisieren.

In der in Fig. 6 gezeigten erfindungsgemäßen Ausführungsform verlaufen die Stromleiter, die den äußeren mit dem inneren Teil der einzelnen Gradientenspulen verbinden, vertikal. Dies ist insofern nützlich, da sich eine solche Stromführung konstruktiv einfach umsetzen lässt, da hier beispielsweise die Möglichkeit bestünde, nach Zusammenfügen der drei Gradientenspulen (bzw. auch zwei zum Beispiel bei einem erfindungsgemäßen x-, y-, z-Gradientensystem) einfach vertikal Löcher in das Befestigungsmaterial zu bohren. In die so entstehenden Öffnungen könnten dann Stromleiterstücke eingefügt werden, die dann außen sowie innen durch verlöten, verschweißen oder durch einen ähnlichen Verarbeitungsschritt mit den noch offenen Enden der jeweiligen Gradientenspule verbunden werden könnten. Dies ist jedoch nur eine von vielen erfindungsgemäßen Realisierungen. Anstelle von vertikalen abrupten Verbindungen können auch nicht-abrupte Verbiegungen von Stromleitern unter Vermeidung von zwei Schweißstellen verwendet werden oder auch nichtvertikale Verbindungen, beispielsweise mit dem Ziel, bessere Stellen für das Queren der einzelnen horizontalen Schichten zu ermöglichen.

**Fig. 7** zeigt ein Beispiel für eine erfindungsgemäße Realisierung eines (im Wesentlichen) zylinderförmigen Gradientensystems, welches Feldgradienten entlang der x-, y- und z-Achse erzeugt. Anders als in Fig. 3 sind hier nur zwei der drei Gradientenspulen im Vergleich zum Stand der Technik modifiziert ausgestaltet. Die Stromleiter der z-Gradientenspule **(074, 078)** befinden sich in den abgebildeten Ausführungsformen auf einer Zylinderoberfläche außen;

dies ist nicht zwingend, wegen der im Vergleich zu Transversalspulen aber höheren Effizienz der Longitudinalspule ist dies aber in der Regel anzuraten. Die Transversalspulen sind hingegen identisch ausgestaltet, lediglich um 90° gegeneinander rotiert.

Möglich wäre es, den erfindungsgemäßen Aufbau, der in Fig. 3b und Fig. 3c gezeigt ist, analog auf zwei Spulen anzuwenden, d.h. zwei Lagen zu konstruieren, die spiralförmig, stufenförmig oder auf ähnliche Weise ineinandergreifen, offen, halb-geschlossen oder geschlossen sind. Jedoch erlaubt bei Transversalspulen die Abwesenheit von Wicklungen um den Spulenkörper grundsätzlich eine offene Ausgestaltung.

Darüber hinaus ist eine weitere Ausgestaltung möglich, in Fig. 7b und Fig. 7c dargestellt, bei der die einzelne Transversalspule nicht aus einem Element, sondern jeweils aus zwei Elementen aufgebaut ist.

Dies wird aus Fig. 7a ersichtlich. Dort ist ein mit der im zweiten Abschnitt zu der detaillierten Beschreibung zu Fig. 1 beschriebenen Methode optimiertes Design 070 für eine Transversalspule gezeigt. Es fällt auf, dass keine Konturlinien (und auch keine Stromleiter) die zwei schwarz gezeichneten Linien **071a, 071b** schneiden. Da die Linien entlang der z-Richtung verlaufen und somit jeweils konstante Azimutalwinkel aufweisen, die um genau 180° gegeneinander rotiert sind, kann die Spulengeometrie entlang dieser Linien in tatsächlicher Hinsicht getrennt werden; es ist allenfalls nötig, in bekannter Weise Zentren der stromführenden Wirbel miteinander über (nicht eingezeichnete) Leiterbrücken zu verbinden (ähnlich wie in Fig. 1 b). Daher kann ein Gradientensystem mit Spulengeometrien wie in Fig. 7b und Fig. 7c gezeigt vorteilhaft sein gegenüber einem Gradientensystem, bei dem eine Aufspaltung der Spulengeometrie in zwei gegenüberliegende Teile nicht vollzogen wird.

Konkret ist in Fig. 7b ein stufenförmiges Gradientensystem in Seitenansicht abgebildet, welches aus den zwei Teilen **(072a, 072b)** einer x-Gradientenspule **072** besteht sowie aus den zwei Teilen **(073a, 073b)** der y-Gradientenspule **073**. Eine Durchdringung der Gradientenspulen findet nicht statt, es handelt sich um ein offenes Design. Der Grund hierfür ist, dass für eine Transversalspule in der Regel keine Wicklungen um den Spulenkörper notwendig sind (vgl. vorheriger Abschnitt). Fig. 7c zeigt ein spiralförmiges Design mit äußerem Radius **075a** und innerem Radius **075b** (deren Differenz von der Dicke der verwendeten stromführenden Leiter und deren Isolierungen abhängt, in der Regel somit wenige Millimeter bis wenige Zentimeter beträgt). Die x-Gradientenspule **076** besteht aus zwei spiralförmig nach außen verlaufenden Elementen **076a, 076b;** um 90° rotiert befinden sich jeweils die entsprechenden Elemente **077a, 077b** der y-Gradientenspule **077**. Die zwei Gradientenspulen **076** und **077** sind somit identisch und werden in geometrischer Hinsicht ineinander überführt, wenn das Gradientensystem um die Längsachse der zylinderförmigen Anordnung (i.e. um die Zylinderachse) um einen Winkel von 90° rotiert wird, unabhängig davon, ob in die eine oder die andere Richtung rotiert wird.

Die Anordnung weist somit hinsichtlich der zwei identischen Gradientenspulen eine 90°-Symmetrie auf, wobei jede Transversalspule aus zwei Elementen besteht, die jeweils in azimutaler Richtung eine Ausdehnung von 180° haben und um 180° gegeneinander rotiert sind, wobei jedes Element selbst offen, spiralförmig (Fig. 7c) oder stufenförmig (Fig. 7b) mit einer Stufe in der Mitte zwischen 0° und 180° ausgestaltet ist. Optional können die Spulen mit möglicherweise ähnlich stufenförmig oder spiralförmig ausgestalteten Kompensationsspulen ausgestattet sein, jedoch entgegengesetzt konstruiert, so dass der Radius nicht im gleichen Uhrzeigersinn anwächst wie der der Hauptspulen (so in Fig. 7b, Fig. 7c), sondern in entgegengesetzter Richtung, analog der im ersten Abschnitt zur detaillierten Beschreibung von Fig. 3 beschriebenen Situation. Die in dem soeben genannten Abschnitt beschriebenen Vor- und Nachteile stufenförmiger bzw. spiralförmiger drei-lagiger Designs gelten in entsprechender Weise auch für die hier beschriebenen erfindungsgemäßen x-y-z-Gradientensysteme. Entsprechendes gilt ebenfalls für die im ersten Abschnitt zur detaillierten Beschreibung von Fig. 3 besprochenen Variationen solcher Designs.

<u>Fig. 8</u> zeigt die Oberfläche **080** einer einzelnen Gradientenspule für ein planares Gradientensystem (oder eines unteren oder oberen Elementes einer Gradientenspule eines biplanaren Gradientensystems) aus zwei Perspektiven, von oben (Fig. 8a) sowie von schräg oben (Fig. 8b).

Die gezeigte Ausführungsform ist kreisförmig, allerdings sind auch andere planare Geometrien denkbar, wie beispielsweise Quadrate oder Rechtecke. Aus dem Stand der Technik sind Oberflächen bekannt, die in einer Ebene liegen. Um ein erfindungsgemäßen Gradientensystem mit identischen, lediglich gegeneinander rotierten Gradientenspulen konstruieren zu können, wird diese planare Geometrie an einer Stelle aufgeschnitten und eine Kante **082** wird gegenüber der anderen Kante **083** nach oben verbogen. Um dies zu ermöglichen, wird in der Mitte eine kleine Öffnung **081** gelassen, die so klein wie möglich gewählt wird, allerdings groß genug, um das zu verbiegende Material nicht zu beschädigen. Die resultierende Fläche von stromführenden Leitern ist nach diesem Vorgang nur noch im Wesentlichen planar. Allerdings wird im Rahmen dieser Erfindung ein Gradientensystem, welches aus solchen im Wesentlichen planaren Gradientenspulen aufgebaut ist, auch als planar (bzw. biplanar) bezeichnet. Diese sprachliche Vereinfachung gilt in der Regel auch für die Gradientenspulen selbst, bzw. für die Flächen, die von den Anordnungen der stromführenden Leiter gebildet werden (obwohl diese Flächen streng genommen eine leichte Krümmung aufweisen). Diese sprachliche Vereinfachung ist auch nützlich, wenn von planaren oder gekrümmten Flächen gesprochen wird.

Nun ist es möglich, zwei (beispielsweise für x- und y-Gradienten) oder drei (beispielsweise für ein Magic-Angle-Gradientensystem) solcher verformten Gradientenspulen ineinander zu legen, so dass sie um 90° (für x- und y-Gradienten) bzw. um 120° (für die drei Magic-Angle-Gradienten) gegeneinander rotiert sind. Abgebildet ist eine Geometrie mit genau einer Rotation; analog der in Fig. 3c dargestellten zylinderförmigen Geometrie ist es aber auch möglich, einen Winkel von mehr als 360° zu wählen, so dass Teile der jeweiligen Gradientenspule (oder Teile von Elementen einer Gradientenspule) überlappen.

Denkbar sind, analog zu den oben ausführlich beschriebenen Ausführungsformen für zylinderförmige erfindungsgemäße Gradientensysteme, auch offene, halb-geschlossene sowie vollständig geschlossene Designs, wobei bei der Verdrahtung eine Herangehensweise gewählt werden kann wie oben im zweiten Abschnitt der detaillierten Beschreibung zu Fig. 6 beschrieben, um eine nützliche Verdrahtung sicherzustellen. Auch sollte in der Regel darauf geachtet werden, dass die Spulen kräftemäßig ausbalanciert sind und es kann oftmals sinnvoll sein, die Hauptspulen mit in geometrischer Hinsicht möglicherweise ähnlich ausgestalteten Kompensationsspulen zu ergänzen.

REFERENZLISTE

Zitierte Patentliteratur

[P1] EP 1 122 552 B1
[P2] US 6 147 494 A
[P3] EP 0 269 146 A2
[P4] EP 0 231 879 B1
[P5] US 5 561 371 A
[P6] US 4 646 024 A
[P7] US 5 177 442 A
[P8] US 5 574 373 A
[P9] EP 2 244 095 B1
[P10] US 5 309 107 A

Dem interessierten Fachmann ist anzuraten, die hier angegebene wissenschaftliche Literatur zu konsultieren, um die vorliegende Erfindung bestmöglich nutzen zu können. An ausgewählten Stellen innerhalb der Beschreibung wird auf die hier angegebene Literatur explizit verwiesen.

[1] P. C. LAUTERBUR, Image formation by induced local interactions: Examples employing nuclear magnetic resonance, Nature, 242 (1973), pp. 190-191.

[2] P. MANSFIELD AND P. K. GRANNELL, NMR "diffraction" in solids?, J. Phys. C: Solid State Phys., 6 (1973), pp. L422-L426.

[3] M. HAACKE, R. W. BROWN, M. R. THOMPSON, AND R. VENKATESAN, Magnetic Resonance Imaging: Physical Principles and Sequence Design, Wiley, 1999.

[4] M. POOLE AND R. BOWTELL, Novel Gradient Coils Designed Using a Boundary Element Method, Concepts in Magn. Reson. Part B 31B (2007), pp. 162 -175.

[5] R. TURNER, A target field approach to optimal coil design, J. Phys. D: Appl. Phys. 19 (1986), pp. L147-L151. doi:10.1088/0022-3727/19/8/001

[6] R. TURNER, Gradient Coil Design: A Review of Methods, Magn. Reson. Imaging 11 (1993), pp. 903-920.

[7] R. A. LEMDIASOV AND R. LUDWIG, A Stream Function Method for Gradient Coil Desig, Concepts in Magn. Reson. Part B 26B (2005), pp. 67 - 80.

[8] G. N. PEEREN, Stream Function Approach for Determining Optimal Surface Currents, J. Comp. Phys. 191 (2003), pp. 305 - 321.

[9] R. WHILE, 3D Gradient Coil Design - Toroidal Surfaces, JMR 198(1) (2009), pp. 31-40.

[10] P. MANSFIELD AND B. CHAPMAN, Active Magnetic Screening of Coils for Static and Time-Dependent Magnetic Field Generation in NMR Imaging, J. Phys. E: Sci. Instrum. 19 (1986), pp. 540 - 545.

[11] R. BOWTELL AND P. MANSFIELD, Gradient Coil Design Using Active Magnetic Screening, Magn. Reson. Med. 17 (1991), pp. 15 - 21.

[12] S. SHVARTSMAN, M. MORICH, G. DEMEESTER AND Z. ZHAI, Ultrashort Shielded Gradient Coil Design with 3D Geometry, Concepts in Magn. Reson. Part B 26B (2005), pp. 1 - 15.

[13] M. S. POOLE, P. T. WHILE, H. S. LOPEZ AND S. CROZIER, Minimax Current Density Gradient Coils: Analysis of Coil Performance and Heating, Magn. Reson. Med. 68 (2012), pp. 639 - 648.

**Patentansprüche**

1.  Gradientensystem für die Magnetresonanzbildgebung, das drei Gradientenspulen (032) umfasst, welche

    a. stromführende Leiter (013) aufweisen, die auf planaren oder gekrümmten Flächen (080, 030a) angeordnet sind, wobei die stromführenden Leiter von n der drei Gradientenspulen, mit n=2 oder n=3, in azimutaler Richtung geschlossen, halb-geschlossen oder offen ausgeformt sind (013, 021) und

    b. jeweils ein magnetisches Gradientenfeld erzeugen, wobei die Gradientenrichtungen orthogonal zueinander sind,

    **dadurch gekennzeichnet,**
    **dass** die planaren oder gekrümmten Flächen (080, 030a) der n Gradientenspulen spiralförmig (036) und/oder stufenförmig (032) ausgeformt sind,
    und **dass** die stromführenden Leiter der n Gradientenspulen identisch ausgeformt sind (038a, 038b, 038c).

2.  Gradientensystem nach Anspruch 1, **dadurch gekennzeichnet, dass** die n identischen Gradientenspulen ineinander überführt werden, wenn das Gradientensystem um eine z-Achse des Gradientensystems im Fall von n = 2 um einen Winkel $\alpha1 = 90°$ oder im Fall von n = 3 um einen Winkel $\alpha2 = 120°$ rotiert wird, unabhängig davon, ob in die eine oder die andere Richtung rotiert wird, das Gradientensystem somit hinsichtlich der n identischen Gradientenspulen im Fall von n = 2 eine 90°-Symmetrie (076, 077) oder im Fall von n = 3 eine 120°-Symmetrie (038a, 038b, 038c) aufweist.

3.  Gradientensystem nach Anspruch 2, **dadurch gekennzeichnet, dass** das Gradientensystem zylinderförmig ausgeformt ist (020) und dass die z-Achse der Zylinderachse entspricht.

4.  Gradientensystem nach Anspruch 3, **dadurch gekennzeichnet, dass** n = 3 und $\alpha2 = 120°$, und dass die Ausdehnung der n Gradientenspulen in azimutaler Richtung 360° beträgt (032).

5.  Gradientensystem nach Anspruch 3, **dadurch gekennzeichnet, dass** n = 3 und $\alpha2 = 120°$, und dass die Ausdehnung der n Gradientenspulen in azimutaler Richtung mehr als 360° beträgt (038a, 038b, 038c).

6.  Gradientensystem nach Anspruch 3, **dadurch gekennzeichnet, dass** n = 2 und $\alpha1 = 90°$, und dass die n = 2 identischen Gradientenspulen Transversalspulen bilden (072, 073), die orthogonale Gradientenfelder in der Transversalebene der zylinderförmigen Geometrie des Gradientensystems erzeugen und die dritte Gradientenspule als Longitudinalspule ausgebildet ist (074), und wobei die zwei Transversalspulen in azimutaler Richtung offen, halb-geschlossen oder geschlossen ausgeformt sind (072, 073).

7.  Gradientensystem nach Anspruch 6, **dadurch gekennzeichnet, dass** jede Transversalspule aus zwei Elementen besteht, die jeweils in azimutaler Richtung eine Ausdehnung von 180° haben und um 180° gegeneinander rotiert sind, wobei jedes Element selbst

    a. offen (072a, 072b),
    b. spiralförmig (076a, 076b) oder
    c. stufenförmig mit einer Stufe in der Mitte zwischen 0° und 180° (072a, 072b)

    ausgestaltet ist.

**8.** Gradientensystem nach Anspruch 2, **dadurch gekennzeichnet, dass** das Gradientensystem planar oder biplanar ausgeformt ist (080), und dass die z-Achse derjenigen Achse entspricht, die orthogonal zu den planaren oder biplanaren Leiteroberflächen orientiert ist.

**9.** Gradientensystem nach Anspruch 8, **dadurch gekennzeichnet, dass** n = 3 und $\alpha2 = 120°$.

**10.** Gradientensystem nach Anspruch 8, **dadurch gekennzeichnet, dass** n = 2 und $\alpha1 = 90°$ beträgt, und dass die n = 2 identischen Gradientenspulen Transversalspulen bilden, die orthogonale Gradientenfelder in der Transversalebene der planaren oder biplanaren Geometrie des Gradientensystems erzeugen, und die dritte Gradientenspule als Longitudinalspule ausgebildet ist.

**11.** Gradientensystem nach einem der vorhergehenden Ansprüche, **dadurch gekennzeichnet, dass** die drei Gradientenspulen durch Kompensationsspulen für eine aktive Abschirmung der magnetischen Felder nach außen ergänzt sind (033).

**12.** Gradientensystem nach einem der vorhergehenden Ansprüche, **dadurch gekennzeichnet, dass** die drei Gradientenspulen kräftemäßig ausbalanciert sind (057).

**13.** Gradientenspule zur Verwendung in einem Gradientensystem nach einem der vorhergehenden Ansprüche, wobei die Gradientenspule stromführende Leiter (013) aufweist, die auf einer planaren oder gekrümmten Fläche (080, 030a) angeordnet und in azimutaler Richtung geschlossen, halbgeschlossen oder offen ausgeformt sind (013, 021), und wobei die Gradientenspule aus einem (038a) oder aus zwei Elementen (072a, 072b) aufgebaut ist und, sofern die Gradientenspule aus einem Element besteht, eine Ausdehnung in azimutaler Richtung von 360° (032) oder mehr (038a, 038b, 038c) hat oder, sofern die Gradientenspule aus zwei Elementen besteht, jedes Element eine Ausdehnung in azimutaler Richtung von 180° (072a, 072b) hat,
**dadurch gekennzeichnet,**
**dass** jedes Element spiralförmig (076a) und/oder stufenförmig (072a) ausgeformt ist.

**14.** Gradientenspule nach Anspruch 13, **dadurch gekennzeichnet, dass** bei (n-1)-fachem identischen Nachbau der Gradientenspule, mit n = 2 oder n = 3, die Flächen, auf denen die stromführenden Leiter der n Gradientenspulen angeordnet sind, sich nicht durchdringen.

Fig. 1a

Fig. 1b

Fig. 2a

Fig. 2b

Fig. 3b

033

035

034b 034a

032

Fig. 3a

031

030

030a

Fig. 3c

037

039b

038a 039a

038c

038b 036

Fig. 4a

Fig. 4b: additional currents

Fig. 4c: compensating currents

Fig. 5a

0°    360°  051b
051a    050

051b
051a

Fig. 5b

053a
0°    360°
053c
050
052a
052b
053b
053d
054

Fig. 5c

0°    360°
056a    056c
050
055a
055b
056b    056d

057
+
+
=
0

Fig. 6a

Fig. 6b

Fig. 7a

Fig. 7b

Fig. 7c

Fig. 8a

080

081

082

083

Fig. 8b

080

081

082

083

Europäisches Patentamt
European Patent Office
Office européen des brevets

**EUROPÄISCHER RECHERCHENBERICHT**

Nummer der Anmeldung

EP 14 19 6601

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X<br>A | US 2010/244836 A1 (HOLLIS TIMOTHY [GB])<br>30. September 2010 (2010-09-30)<br>* Absatz [0003] - Absatz [0005] *<br>* Absätze [0037], [0038] *<br>----- | 1-3,6,7,<br>11-14<br>4,5 | INV.<br>G01R33/385 |
| X | DE 199 43 372 A1 (SIEMENS AG [DE])<br>12. April 2001 (2001-04-12)<br>* Spalte 4, Zeile 14 - Zeile 37; Ansprüche 1,4 *<br>----- | 1 | |
| X<br>A | US 5 874 831 A (YI JEONG-HAN [KR] ET AL)<br>23. Februar 1999 (1999-02-23)<br>* Abbildung 4 *<br>----- | 1,8,10<br><br>9 | |
| X | DE 10 2004 005278 A1 (SIEMENS AG [DE])<br>18. August 2005 (2005-08-18)<br>* Absatz [0039] *<br>----- | 1 | |
| A | WO 03/052443 A2 (KONINKL PHILIPS<br>ELECTRONICS NV [NL]; HAM CORNELIS L G<br>[NL]; OVERWEG JO)<br>26. Juni 2003 (2003-06-26)<br>* Seite 6, Zeile 30 - Seite 7, Zeile 15 *<br>----- | 1 | RECHERCHIERTE SACHGEBIETE (IPC)<br><br>G01R |
| A | EP 1 122 552 A2 (PHILIPS CORP INTELLECTUAL<br>PTY [DE]; KONINKL PHILIPS ELECTRONICS NV<br>[NL] 8. August 2001 (2001-08-08)<br>* Ansprüche 1-7 *<br>----- | 1,4,5,9 | |
| A | BOWTELL R ET AL: "MAGIC-ANGLE<br>GRADIENT-COIL DESIGN",<br>JOURNAL OF MAGNETIC RESONANCE. SERIES A,<br>ACADEMIC PRESS, ORLANDO, FL, US,<br>Bd. 115, Nr. 1, 1. Juli 1995 (1995-07-01),<br>Seiten 55-59, XP000519712,<br>ISSN: 1064-1858, DOI:<br>10.1006/JMRA.1995.1148<br>* das ganze Dokument *<br>----- | 1,4,5,9 | |

Der vorliegende Recherchenbericht wurde für alle Patentansprüche erstellt

| Recherchenort | Abschlußdatum der Recherche | Prüfer |
|---|---|---|
| München | 7. April 2015 | Skalla, Jörg |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**                    EP 14 19 6601

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

07-04-2015

| Im Recherchenbericht angeführtes Patentdokument | Datum der Veröffentlichung | Mitglied(er) der Patentfamilie | Datum der Veröffentlichung |
|---|---|---|---|
| US 2010244836 A1 | 30-09-2010 | KEINE | |
| DE 19943372 A1 | 12-04-2001 | DE 19943372 A1<br>JP 2001112737 A<br>US 6448774 B1 | 12-04-2001<br>24-04-2001<br>10-09-2002 |
| US 5874831 A | 23-02-1999 | JP 3707894 B2<br>JP H09224921 A<br>US 5874831 A | 19-10-2005<br>02-09-1997<br>23-02-1999 |
| DE 102004005278 A1 | 18-08-2005 | CN 1672634 A<br>DE 102004005278 A1<br>GB 2411237 A<br>US 2005198812 A1 | 28-09-2005<br>18-08-2005<br>24-08-2005<br>15-09-2005 |
| WO 03052443 A2 | 26-06-2003 | AU 2002366419 A1<br>CN 1695067 A<br>EP 1456682 A2<br>JP 2005512646 A<br>US 2005122106 A1<br>WO 03052443 A2 | 30-06-2003<br>09-11-2005<br>15-09-2004<br>12-05-2005<br>09-06-2005<br>26-06-2003 |
| EP 1122552 A2 | 08-08-2001 | DE 10004765 A1<br>EP 1122552 A2<br>JP 2001238867 A<br>US 6429655 B1 | 09-08-2001<br>08-08-2001<br>04-09-2001<br>06-08-2002 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1122552 B1
- US 5309107 A
- US 6147494 A
- EP 0269146 A2
- EP 0231879 B1
- US 5561371 A
- US 4646024 A
- US 5177442 A
- US 5574373 A
- EP 2244095 B1

**In der Beschreibung aufgeführte Nicht-Patentliteratur**

- **P. C. LAUTERBUR.** Image formation by induced local interactions: Examples employing nuclear magnetic resonance. *Nature,* 1973, vol. 242, 190-191
- **P. MANSFIELD ; P. K. GRANNELL.** NMR ''diffraction'' in solids?. *J. Phys. C: Solid State Phys.,* 1973, vol. 6, L422-L426
- **M. HAACKE ; R. W. BROWN ; M. R. THOMPSON ; R. VENKATESAN.** Magnetic Resonance Imaging: Physical Principles and Sequence Design. Wiley, 1999
- **M. POOLE ; R. BOWTELL.** Novel Gradient Coils Designed Using a Boundary Element Method. *Concepts in Magn. Reson.,* 2007, vol. 31B, 162-175
- **R. TURNER.** A target field approach to optimal coil design. *J. Phys. D: Appl. Phys.,* 1986, vol. 19, L147-L151
- **R. TURNER.** Gradient Coil Design: A Review of Methods. *Magn. Reson. Imaging,* 1993, vol. 11, 903-920
- **R. A. LEMDIASOV ; R. LUDWIG.** A Stream Function Method for Gradient Coil Desig. *Concepts in Magn. Reson,* 2005, vol. 26B, 67-80
- **G. N. PEEREN.** Stream Function Approach for Determining Optimal Surface Currents. *J. Comp. Phys.,* 2003, vol. 191, 305-321
- **R. WHILE.** 3D Gradient Coil Design - Toroidal Surfaces. *JMR,* 2009, vol. 198 (1), 31-40
- **P. MANSFIELD ; B. CHAPMAN.** Active Magnetic Screening of Coils for Static and Time-Dependent Magnetic Field Generation in NMR Imaging. *J. Phys. E: Sci. Instrum.,* 1986, vol. 19, 540-545
- **R. BOWTELL ; P. MANSFIELD.** Gradient Coil Design Using Active Magnetic Screening. *Magn. Reson. Med.,* 1991, vol. 17, 15-21
- **S. SHVARTSMAN ; M. MORICH ; G. DEMEESTER ; Z. ZHAI.** Ultrashort Shielded Gradient Coil Design with 3D Geometry. *Concepts in Magn. Reson.,* 2005, vol. 26B, 1-15
- **M. S. POOLE ; P. T. WHILE ; H. S. LOPEZ ; S. CROZIER.** Minimax Current Density Gradient Coils: Analysis of Coil Performance and Heating. *Magn. Reson. Med.,* 2012, vol. 68, 639-648